(19) Europäisches Patentamt / European Patent Office / Office européen des brevets

(11) **EP 3 528 300 A1**

(12) **EUROPEAN PATENT APPLICATION**
published in accordance with Art. 153(4) EPC


(43) Date of publication:
**21.08.2019 Bulletin 2019/34**

(21) Application number: **17860825.3**

(22) Date of filing: **12.10.2017**

(51) Int Cl.:
***H01L 51/50*** *(2006.01)* ***C08G 61/12*** *(2006.01)*
***H01L 27/32*** *(2006.01)* ***H05B 33/10*** *(2006.01)*

(86) International application number:
**PCT/JP2017/036925**

(87) International publication number:
**WO 2018/070460 (19.04.2018 Gazette 2018/16)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **13.10.2016 JP 2016201884**



(71) Applicant: **Hitachi Chemical Company, Ltd.**
**Chiyoda-ku**
**Tokyo 100-6606 (JP)**

(72) Inventors:
- **SUGIOKA Tomotsugu**
**Tokyo 100-6606 (JP)**
- **FUNYUU Shigeaki**
**Tokyo 100-6606 (JP)**
- **ASANO Naoki**
**Tokyo 100-6606 (JP)**
- **ISHITSUKA Kenichi**
**Tokyo 100-6606 (JP)**
- **YOSHINARI Yuki**
**Tokyo 100-6606 (JP)**

(74) Representative: **Adam, Holger**
**Kraus & Weisert**
**Patentanwälte PartGmbB**
**Thomas-Wimmer-Ring 15**
**80539 München (DE)**


(54) **ORGANIC ELECTRONICS MATERIAL, INK COMPOSITION, AND ORGANIC ELECTRONICS ELEMENT**


(57) One embodiment relates to an organic electronic material containing a charge transport polymer or oligomer, wherein the charge transport polymer or oligomer has a nitrogen atom and an aromatic hydrocarbon group $Ar^F$ that is bonded to the nitrogen atom and is substituted with a fluorine atom, and also has a structural unit containing a carbazole structure.


FIG. 1

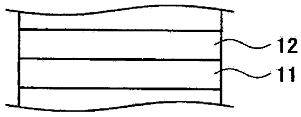



EP 3 528 300 A1

## Description

### Technical Field

The present disclosure relates to an organic electronic material, an ink composition, an organic layer, an organic electronic element, an organic electroluminescent element (organic EL element), a display element, an illumination device and a display device, and also relates to methods for producing an organic layer, an organic electronic element and an organic EL element.

### Background Art

Organic electronic elements are elements which use an organic substance to perform an electrical operation. It is anticipated that organic electronic elements will be capable of providing advantages such as lower energy consumption, lower prices and greater flexibility, and they are therefore attracting considerable attention as a potential alternative technology to conventional inorganic semiconductors containing mainly silicon.

Among organic electronic elements, organic EL elements are attracting attention for potential use in large-surface area solid state lighting applications to replace incandescent lamps or gas-filled lamps. Further, organic EL elements are also attracting attention as the leading self-luminous display for replacing liquid crystal displays (LCD) in the field of flat panel displays (FPD), and commercial products are becoming increasingly available.

In recent years, the size of organic EL elements has continued to increase, and in order to enable formation of the elements with greater efficiency, methods of forming organic layers by using a wet process such as a spin coating method or inkjet method to apply an ink composition containing a charge transport polymer are being investigated (for example, see Patent Literature 1).

### Citation List

#### Patent Literature

PLT 1: WO 2011/040531

### Summary of Invention

#### Technical Problem

An organic EL element produced using a charge transport polymer has the advantages of facilitating cost reductions and increases in the element surface area. However, further improvements in the characteristics of organic EL elements would be desirable.

Accordingly, the present disclosure provides an organic electronic material, an ink composition and an organic layer that are suited to improving the characteristics of organic electronic elements. Further, this disclosure also provides an organic electronic element, an organic EL element, a display element, an illumination device and a display device that have excellent element characteristics. Moreover, this disclosure also provides methods for efficiently producing the aforementioned organic layer, organic electronic element and organic EL element.

#### Solution to Problem

As a result of intensive investigation, the inventors of the present invention discovered that by using a charge transport polymer containing specific structures, the characteristics of organic EL elements could be improved, and they were therefore able to complete the present invention.

Examples of the embodiments of the present invention are described below. However, the present invention is not limited to the following embodiments.

One embodiment relates to an organic electronic material containing a charge transport polymer or oligomer, wherein the charge transport polymer or oligomer has a nitrogen atom and an aromatic hydrocarbon group $Ar^F$ that is bonded to the nitrogen atom and is substituted with a fluorine atom, and also has a structural unit containing a carbazole structure.

In one preferred embodiment, the charge transport polymer or oligomer has a structural unit containing an aromatic amine structure, and the structural unit has the aromatic hydrocarbon group $Ar^F$ described above.

In one preferred embodiment, the nitrogen atom contained in the above carbazole structure is either unsubstituted, or has an aliphatic hydrocarbon group or an aromatic hydrocarbon group, and the structural unit containing the

carbazole structure has the aromatic hydrocarbon group $Ar^F$ described above.

Another embodiment relates to an ink composition containing the above organic electronic material and a solvent.

Another embodiment relates to an organic layer containing the above organic electronic material.

Another embodiment relates to an organic electronic element having at least one of the above organic layer.

Another embodiment relates to an organic electroluminescent element having at least one of the above organic layer.

Other embodiments relate to a display element and an illumination device containing the above organic electroluminescent element, and to a display device containing the above illumination device and a liquid crystal element as a display unit.

Other embodiments relate to a method for producing an organic layer that includes a step of applying the above ink composition, a method for producing an organic electronic element that includes a step of applying the above ink composition, and a method for producing an organic electroluminescent element that includes a step of applying the above ink composition.

The present invention is related to the subject matter disclosed in prior Japanese Application 2016-201884 filed on October 13, 2016, the entire contents of which are incorporated by reference herein.

Advantageous Effects of Invention

The present disclosure is able to provide an organic electronic material, an ink composition and an organic layer that are suited to improving the characteristics of organic electronic elements. Further, this disclosure is also able to provide an organic electronic element, an organic EL element, a display element, an illumination device and a display device that have excellent element characteristics. Moreover, this disclosure is also able to provide methods for efficiently producing the aforementioned organic layer, organic electronic element and organic EL element.

Brief Description of Drawings

FIG. 1 is a cross-sectional schematic view illustrating one example of a structure contained in an organic EL element of one embodiment.

FIG. 2 is a schematic view illustrating one example of an organic EL element of one embodiment.

Description of Embodiments

Embodiments of the present invention are described below. However, the present invention is not limited to the following embodiments.

<Organic Electronic Material>

According to one embodiment, an organic electronic material contains at least a charge transport polymer or oligomer having a nitrogen atom and an aromatic hydrocarbon group $Ar^F$ that is bonded to the nitrogen atom and is substituted with a fluorine atom, and also having a structural unit containing a carbazole structure (hereafter this charge transport polymer or oligomer is sometimes referred to as the "charge transport polymer I"). The organic electronic material may contain only one type of the charge transport polymer I, or may contain two or more types.

Generally, a charge transport polymer used in an organic electronic material contains repeating carbon-carbon single bonds (C-C) and carbon-carbon double bonds (C=C) within the molecule, and has a well-developed conjugated system. Accordingly, the energy gap between the HOMO (highest occupied molecular orbital) and the LUMO (lowest unoccupied molecular orbital) tends to be small (namely, the energy gap between the $S_0$ level (singlet ground state) and the $S_1$ level (excited singlet state) tends to be small), and the energy gap between the $S_0$ level (singlet ground state) and the $T_1$ level (excited triplet state) also tends to be small (hereafter, the "energy gap between the $S_0$ level and the $S_1$ level" is also referred to as the "$S_1$ energy", and the "energy gap between the $S_0$ level and the $T_1$ level" is also referred to as the "$T_1$ energy"). A conjugated system is a required structure in order for the polymer to exhibit conductivity, but on the other hand, the charge transport polymer may require suitable energy levels for HOMO and LUMO and the like and suitable energy gaps depending on the intended application.

For example, from the viewpoint of enabling easier injection of holes into the light-emitting layer and from the viewpoint of suppressing intermolecular interactions with the material of the light-emitting layer, it is sometimes desirable that the charge transport polymer used as the material for the hole transport layer of an organic EL element has a deep

HOMO level. Further, from the viewpoints of suppressing energy transfer of excitons produced in the light-emitting layer, and enabling light emission to be performed efficiently, it is sometimes desirable that the charge transport polymer has a large HOMO-LUMO energy gap ($S_1$ energy) and/or a large $T_1$ energy. The demands for characteristics including a deep HOMO level and a large $S_1$ energy and/or $T_1$ energy increase particularly when the emission wavelength from the light-emitting layer shortens. However, designing a charge transport polymer having the desired energy levels and energy gaps is not an easy task.

As a result of intensive investigation, the inventors of the present invention discovered that by introducing into a charge transport polymer a structural unit containing a carbazole structure as well as a nitrogen atom and an aromatic hydrocarbon group $Ar^F$, a deep HOMO level could be obtained, and the $S_1$ energy and/or $T_1$ energy could be adjusted significantly. As a result, a charge transport polymer having suitable energy levels and energy gaps could be provided.

By using a charge transport polymer having suitable energy levels and energy gaps, the compatibility between organic layers can be improved, and the characteristics of organic electronic elements can be enhanced. For example, an improvement in the light emission efficiency, an improvement in the lifespan characteristics, or a reduction in the drive voltage of an organic EL element, or alternatively, an improvement in the conversion efficiency of an organic photoelectric conversion element, can be expected.

[Charge Transport Polymer I]

The charge transport polymer I contains a nitrogen atom and an aromatic hydrocarbon group $Ar^F$ that is bonded to the nitrogen atom and is substituted with a fluorine atom, and also contains a structural unit containing a carbazole structure. The charge transport polymer I has the ability to transport charge, and preferably has the ability to transport positive holes. It is thought that by including the nitrogen atom and the aromatic hydrocarbon group $Ar^F$ that is bonded to the nitrogen atom, the HOMO level of the charge transport polymer I can be deepened. Further, it is thought that by including the structural unit containing a carbazole structure, any reductions in the $S_1$ level and the $T_1$ level can be suppressed. As a result of including these structures, it is surmised that the charge transport polymer I displays a deep HOMO level as well as a large $S_1$ energy and/or $T_1$ energy.

The charge transport polymer I may be a linear polymer or a branched polymer. From the viewpoints of facilitating more precise control of the molecular weight of the polymer and the physical properties of the ink composition, a linear polymer is preferred, but from the viewpoint of making it easier to increase the molecular weight, a branched polymer is preferred. A branched polymer is also preferred from the viewpoint of enhancing the durability of the organic electronic element.

A linear charge transport polymer I has no branched portions on the polymer chain, and has two terminals. The linear charge transport polymer I contains a divalent structural unit that forms the polymer chain, and a monovalent structural unit that forms the terminal portions. A branched charge transport polymer I has one or more branched portions on the polymer chain, and has three or more terminals. The branched charge transport polymer I contains a trivalent structural unit that forms the branched portion, and a monovalent structural unit that forms the terminal portions, and may also contain a divalent structural unit. The branched charge transport polymer I has a main chain and at least one branch chain (side chain), and each side chain contains either one, or two or more, structural units.

(Nitrogen Atom, and Aromatic Hydrocarbon Group $Ar^F$ Bonded to the Nitrogen Atom)

The aromatic hydrocarbon group $Ar^F$ is bonded to the nitrogen atom, and at least one hydrogen atom that is bonded to an $sp^2$ carbon within the structure is substituted with a fluorine atom. An $sp^2$ carbon refers to a carbon atom that forms an aromatic ring of the aromatic hydrocarbon group, and is a carbon atom that adopts an $sp^2$ hybrid orbital. The "aromatic hydrocarbon" is the same as the "aromatic hydrocarbon" of a structural unit $AA^F$ described below. The upper limit for the number of fluorine atoms within a single aromatic hydrocarbon group $Ar^F$ is determined by the structure of the aromatic hydrocarbon group $Ar^F$, but for example in the case where the aromatic hydrocarbon group $Ar^F$ is a benzene structure, the upper limit is not more than 5 fluorine atoms, whereas for a naphthalene structure, the upper limit is not more than 7 fluorine atoms. There are no particular limitations on the substitution position(s) for the fluorine atom(s).

Examples of the "nitrogen atom and the aromatic hydrocarbon group $Ar^F$ that is bonded to the nitrogen atom" contained within the charge transport polymer I are shown below. However, the "nitrogen atom and the aromatic hydrocarbon group $Ar^F$ that is bonded to the nitrogen atom" are not limited to the following structure. In the present description, "*" denotes a bonding site to another structure.

[Chemical formula 1]

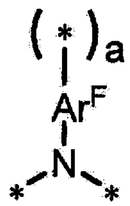

$Ar^F$ is bonded to the nitrogen atom, and is an aromatic hydrocarbon group in which at least one hydrogen atom that is bonded to an $sp^2$ carbon within the structure is substituted with a fluorine atom. Further, a represents an integer of 0 or greater, with the upper limit being determined by the structure of the aromatic hydrocarbon group.

Specific examples are shown below.

[Chemical formula 2]

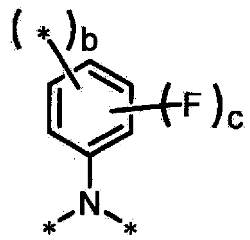

In the above formula, b represents an integer of 0 to 4, and c represents an integer of 1 to 5, provided that b+c≤5. Further, b is preferably from 0 to 3, and more preferably from 0 to 2.

More specific examples include those shown below.

[Chemical formula 3]

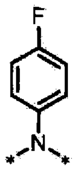 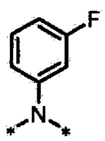 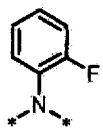 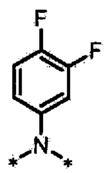 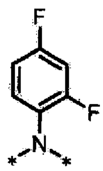 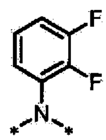 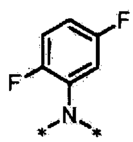 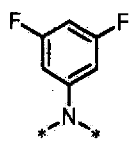

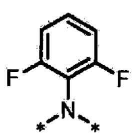 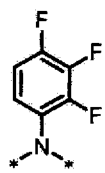 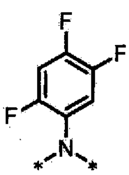 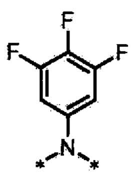 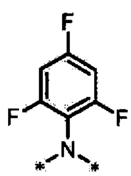 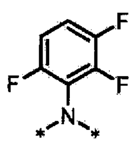 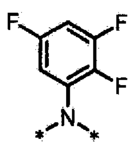 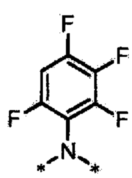

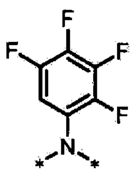 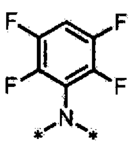 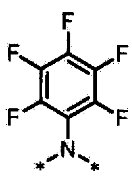

[Chemical formula 4]

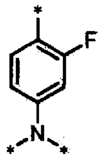
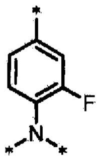
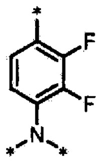
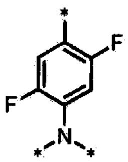
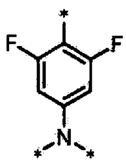
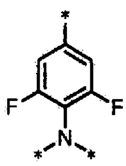
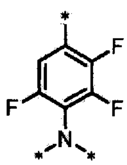
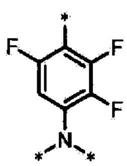
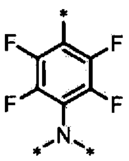
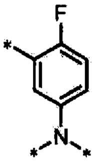
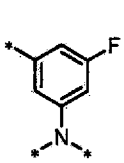
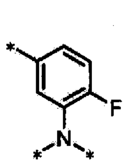
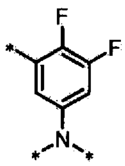
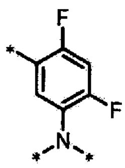
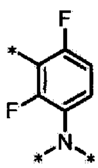
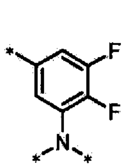
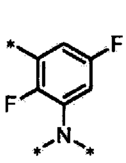
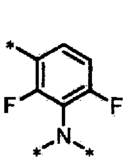
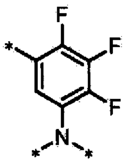
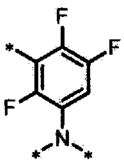
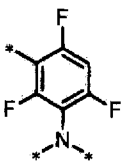
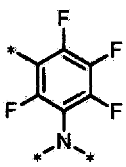
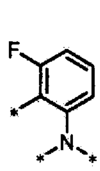
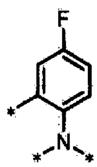
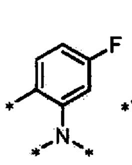
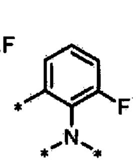
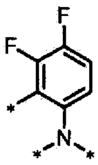
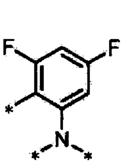
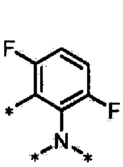
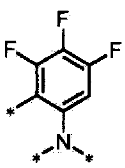
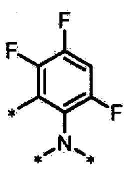
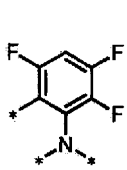
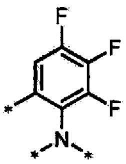
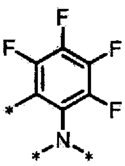

[Chemical formula 5]

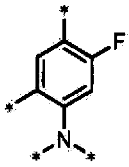
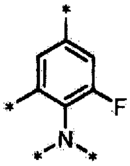
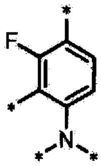
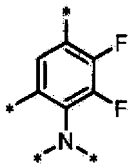
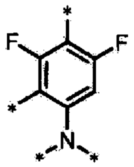
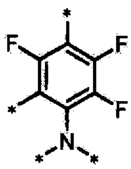

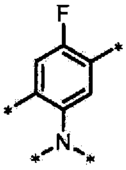
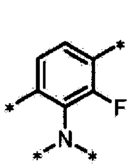
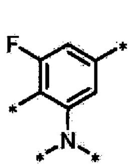
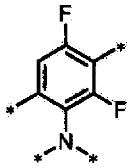
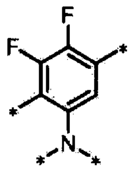
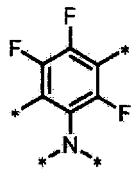

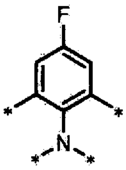
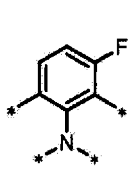
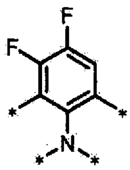
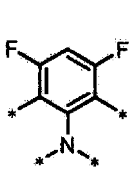
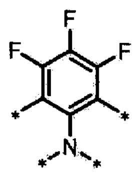

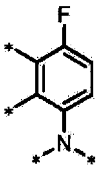
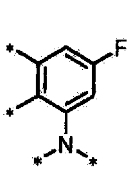
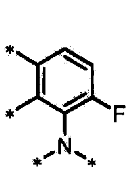
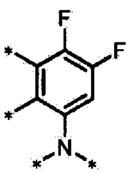
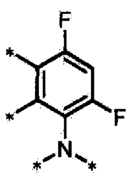
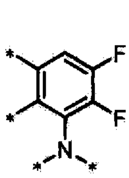
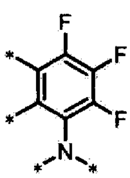

The nitrogen atom and the aromatic hydrocarbon group $Ar^F$ are, for example, contained as partial structures within a structural unit containing an aromatic amine structure or a structural unit containing a carbazole structure or the like (hereafter a "structural unit containing an aromatic amine structure" having "a nitrogen atom and an aromatic hydrocarbon group $Ar^F$" is termed a "structural unit $AA^F$", and a "structural unit containing a carbazole structure" having "a nitrogen atom and an aromatic hydrocarbon group $Ar^F$" is termed a "structural unit $CZ^F$"). The charge transport polymer I preferably has at least one of a structural unit $AA^F$ and a structural unit $CZ^F$.

(Structural Unit Containing a Carbazole Structure)

In the structural unit containing a carbazole structure, a hydrogen atom may be bonded to the nitrogen atom contained within the carbazole structure (unsubstituted), or a monovalent organic group or a divalent or higher organic group may be bonded to the nitrogen atom. Examples of the monovalent organic group include a monovalent aromatic hydrocarbon group and a monovalent aliphatic hydrocarbon group. Further, examples of the divalent or higher organic group include a divalent or higher aromatic hydrocarbon group and a divalent or higher aliphatic hydrocarbon group.

The two benzene rings and the aromatic hydrocarbon group bonded to the nitrogen atom contained within the carbazole structure may each be independently substituted with a fluorine atom. In this case, the structural unit containing a carbazole structure becomes a structural unit containing the aromatic hydrocarbon group $Ar^F$. Further, the two benzene rings and the aromatic hydrocarbon group bonded to the nitrogen atom contained within the carbazole structure may all be unsubstituted with fluorine atoms. In other words, the structural unit containing a carbazole structure may be a structural unit that does not include the aromatic hydrocarbon group $Ar^F$ (hereafter a "structural unit containing a carbazole structure" which does not include "a nitrogen atom and an aromatic hydrocarbon group $Ar^F$" is termed a "structural unit CZ"). The charge transport polymer I has at least one of the structural unit $CZ^F$ and the structural unit CZ.

(Structural Units)

In one preferred embodiment, the charge transport polymer I has at least the structural unit $AA^F$ and the structural unit CZ. The charge transport polymer I may also have the structural unit $CZ^F$. Further, in another preferred embodiment, the charge transport polymer I has at least the structural unit $CZ^F$. The charge transport polymer I may also have the

structural unit $AA^F$ and/or the structural unit CZ. In either of these embodiments, the charge transport polymer I may also have one or more other optional structural units besides the structural unit $AA^F$, the structural unit $CZ^F$ and the structural unit CZ. The charge transport polymer I may have one type of each structural unit, or may have two or more types of each structural unit.

Each of the structural units is described below.

(Structural Unit $AA^F$)

The structural unit $AA^F$ contains an aromatic amine structure having the aromatic hydrocarbon group $Ar^F$ bonded to the nitrogen atom (hereafter this aromatic amine structure is referred to as the "aromatic amine structure $AA^F$").

The aromatic amine structure has a nitrogen atom and an aromatic hydrocarbon group bonded to the nitrogen atom. Here, examples of the "aromatic hydrocarbon" include monocyclic aromatic hydrocarbons and condensed polycyclic aromatic hydrocarbons. Examples of the condensed polycyclic aromatic hydrocarbons include condensed ring structures containing 2 to 10 benzene rings, and the number of benzene rings is preferably from 2 to 5, and more preferably 2 or 3.

Specific examples of the aromatic hydrocarbon include benzene (1), naphthalene (2), fluorene (2), anthracene (3), tetracene (4), pentacene (5), phenanthrene (3), chrysene (4), triphenylene (4), tetraphene (4), pyrene (4), picene (5), pentaphene (5), perylene (5), pentahelicene (5), hexahelicene (6), heptahelicene (7), coronene (7), fluoranthene (3), acephenanthrylene (3), aceanthrene (3), aceanthrylene (3), pleiadene (4), tetraphenylene (4), cholanthrene (4), dibenzanthracene (5), benzopyrene (5), rubicene (5), hexaphene (6), hexacene (6), trinaphthylene (7), heptaphane (7), heptacene (7), pyranthrene (8) and ovalene (10). The numbers in parentheses indicate the numbers of benzene rings contained in the aromatic hydrocarbons.

The number of carbon atoms in the aromatic hydrocarbon group is preferably from 6 to 30, more preferably from 6 to 20, even more preferably from 6 to 14, and particularly preferably from 6 to 10. From the viewpoint of improving the characteristics of the organic electronic element, the aromatic hydrocarbon is preferably benzene, naphthalene, fluorene, anthracene or phenanthrene, is more preferably benzene or naphthalene, and is even more preferably benzene.

The number of aromatic hydrocarbon groups contained in the aromatic amine structure $AA^F$ is from 1 to 3. From the viewpoint of obtaining superior charge transport properties, this number is preferably 2 or 3, and more preferably 3. Excluding substituents, the aromatic hydrocarbon groups contained in the aromatic amine structure $AA^F$ may be the same or different. Preferred examples of the aromatic amine structure $AA^F$ include diarylamine structures and triarylamine structures. Triarylamine structures are particularly preferred. Here, the term "aryl" means an atom grouping in which one hydrogen atom has been removed from an aromatic hydrocarbon described above. The number of fluorine atoms in each aromatic hydrocarbon group may be either 0, or 1 or greater.

The aromatic amine structure $AA^F$ has at least one aromatic hydrocarbon group $Ar^F$. The upper limit for the number of fluorine atoms contained within a single aromatic hydrocarbon group $Ar^F$ is determined by the structure of the aromatic hydrocarbon group $Ar^F$, and for example is not more than 5 when the aromatic hydrocarbon group $Ar^F$ is a benzene structure, or not more than 7 in the case of a naphthalene structure. There are no particular limitations on the substitution position(s) of the fluorine atom(s). In those cases where the aromatic hydrocarbon group $Ar^F$ is substituted with one or two fluorine atoms at the ortho position(s) relative to the bonding site with another structure, the lowering effect on the HOMO level, or the increase effect on the $S_1$ energy and/or $T_1$ energy tends to be more readily obtained.

The number of fluorine atoms contained in the aromatic amine structure $AA^F$ is at least one. Further, from the viewpoint of improving the characteristics of the organic electronic element, the upper limit for the number of fluorine atoms is preferably not more than 8, more preferably not more than 6, and even more preferably not more than 4. In particular, when the number of fluorine atoms is 3 or fewer, the lowering effect on the HOMO level, or the increase effect on the $S_1$ energy and/or $T_1$ energy tends to be more readily obtained.

In one embodiment, considering the effect of substituent groups, the aromatic amine structure $AA^F$ may have no substituents other than the fluorine atom(s). Further, in another embodiment, from the viewpoint of imparting desired functionality to the charge transport polymer I, the aromatic amine structure $AA^F$ may also have a substituent other than a fluorine atom (hereafter a "substituent other than a fluorine atom" is sometimes termed a "substituent Ra"). Examples of the substituent Ra include $-R^1$ (but excluding the case of a hydrogen atom), $-OR^2$, $-SR^3$, $-OCOR^4$, $-COOR^5$, $-SiR^6R^7R^8$, -CN,$-NO_2$, -Cl, -Br, and groups containing a polymerizable functional group described below. Each of $R^1$ to $R^8$ independently represents a hydrogen atom; a linear, cyclic or branched alkyl group (preferably of 1 to 22 carbon atoms); an aryl group (preferably of 6 to 30 carbon atoms); or a heteroaryl group (preferably of 2 to 30 carbon atoms). The alkyl group may be further substituted with an aryl group (preferably of 6 to 30 carbon atoms) or a heteroaryl group (preferably of 2 to 30 carbon atoms), and the aryl group or heteroaryl group may be further substituted with a linear, cyclic or branched alkyl group (preferably of 1 to 22 carbon atoms). Further, the alkyl group may be substituted with a halogen atom (for example, $-CF_3$).

Examples of the alkyl group include a methyl group, ethyl group, n-propyl group, n-butyl group, n-pentyl group,

n-hexyl group, n-heptyl group, n-octyl group, n-nonyl group, n-decyl group, n-undecyl group, n-dodecyl group, isopropyl group, isobutyl group, sec-butyl group, tert-butyl group, 2-ethylhexyl group, 3,7-dimethyloctyl group, cyclohexyl group, cycloheptyl group and cyclooctyl group. References to alkyl groups in the following description have the same meaning.

An aryl group is an atom grouping in which one hydrogen atom has been removed from an aromatic hydrocarbon. A heteroaryl group is an atom grouping in which one hydrogen atom has been removed from an aromatic heterocycle. Examples of the aromatic hydrocarbon include monocyclic rings, condensed rings, and polycyclic rings in which two or more (preferably not more than 5, and more preferably 3 or fewer) rings selected from among monocyclic rings and condensed rings are bonded together via single bonds. Examples of the aromatic heterocycles include monocyclic rings, condensed rings, and polycyclic rings in which two or more (preferably not more than 5, and more preferably 3 or fewer) rings selected from among monocyclic rings and condensed rings are bonded together via single bonds. Specific examples of the aromatic hydrocarbon include benzene, biphenyl, terphenyl, triphenylbenzene, naphthalene, anthracene, tetracene, fluorene and phenanthrene. Examples of the aromatic heterocycle include pyridine, pyrazine, quinoline, isoquinoline, acridine, phenanthroline, furan, pyrrole, thiophene, carbazole, oxazole, oxadiazole, thiadiazole, triazole, benzoxazole, benzoxadiazole, benzothiadiazole, benzotriazole, and benzothiophene. References to aryl groups and heteroaryl groups, and the aromatic hydrocarbons and aromatic heterocycles contained in such groups in the following description have the same meanings.

For example, in order to impart improved solubility in organic solvents, the aromatic hydrocarbon group in the aromatic amine structure $AA^F$ may have an alkyl group of 1 to 12 carbon atoms. This number of carbon atoms is preferably from 1 to 10, and more preferably from 1 to 8. There are no particular limitations on the substitution position of the alkyl group, but considering the effects on the element characteristics, a position on the aromatic hydrocarbon group that does not participate in bonding with another structure may be used. The alkyl group is preferably a methyl group, ethyl group, n-propyl group, isopropyl group, isobutyl group, n-butyl group, sec-butyl group, tert-butyl group, n-pentyl group, n-hexyl group, cyclohexyl group, n-heptyl group, n-octyl group, n-decyl group, or 2-ethylhexyl group or the like.

For example, in order to lower the HOMO level or increase the $S_1$ energy and/or $T_1$ energy, the aromatic hydrocarbon group in the aromatic amine structure $AA^F$ may have an alkyl group of 1 to 6 carbon atoms at the ortho position relative to the bonding site with another structure. The number of carbon atoms of the alkyl group is preferably from 1 to 3, and is more preferably 1. The alkyl group is preferably a methyl group, ethyl group, n-propyl group, isopropyl group, isobutyl group, n-butyl group, sec-butyl group, tert-butyl group, n-pentyl group, n-hexyl group, or cyclohexyl group or the like.

In those cases where the aromatic amine structure $AA^F$ has the aromatic hydrocarbon group $Ar^F$ and an aromatic hydrocarbon group that is not substituted with a fluorine atom, the aforementioned substituent Ra may exist in the aromatic hydrocarbon group $Ar^F$ or in the aromatic hydrocarbon group that is not substituted with a fluorine atom. In either case, the number of substituents Ra contained in one aromatic hydrocarbon group may be either 0, or 1 or greater, and is preferably either 0 or 1. From the viewpoint of improving the characteristics of the organic electronic element, the upper limit for the number of substituents Ra contained in the aromatic amine structure $AA^F$ is preferably not more than 8, more preferably not more than 6, even more preferably not more than 4, and particularly preferably 3 or fewer.

The aromatic amine structure $AA^F$ has one or more bonding sites and is monovalent or higher, with the structure being mutually bonded to another structure at each of these bonding sites. From the viewpoint of improving the characteristics of organic electroluminescent elements, or from the viewpoint of enabling more favorable synthesis of the polymer or the like, the aromatic amine structure $AA^F$ is preferably hexavalent or lower, more preferably tetravalent or lower, and even more preferably divalent or trivalent.

Examples of the aromatic amine structure $AA^F$ include the structures shown below. However, the aromatic amine structure $AA^F$ is not limited to the following structures.

<<Divalent Aromatic Amine Structures $AA^F$>>

Examples of divalent aromatic amine structures $AA^F$ include those shown below.

[Chemical formula 6]

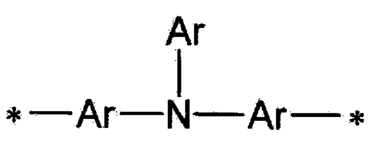

Each Ar independently represents an aromatic hydrocarbon group, and at least one Ar is the aromatic hydrocarbon group $Ar^F$. Each Ar may be independently substituted with a substituent Ra.

Specific examples include the structures shown below.

[Chemical formula 7]

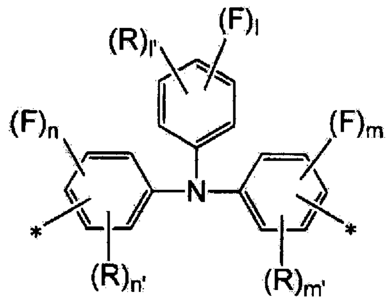

Each R independently represents a substituent Ra, each of l and l' independently represents an integer of 0 to 5, and each of m, m', n and n' independently represents an integer of 0 to 4, provided that $l+m+n \geq 1$, $l+l' \leq 5$, $m+m' \leq 4$, and $n+n' \leq 4$.

The subscripts l, l', m, m', n and n' indicate the numbers of F and R. This convention also applies in subsequent formulas.

More specific examples are shown below.

[Chemical formula 8]

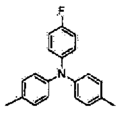 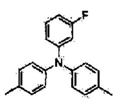 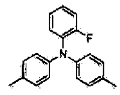 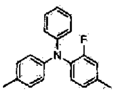 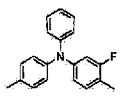 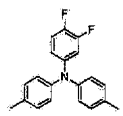 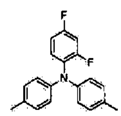 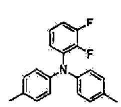

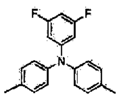 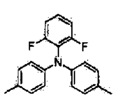 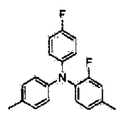 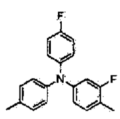 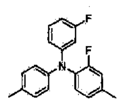 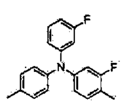 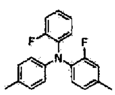 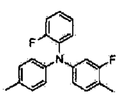

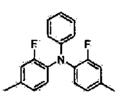 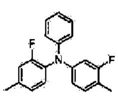 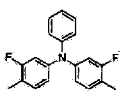 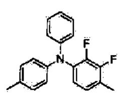 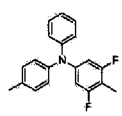 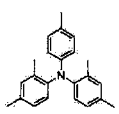 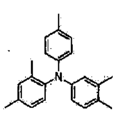 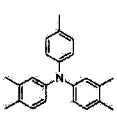

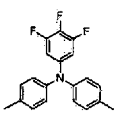 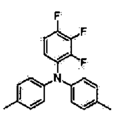 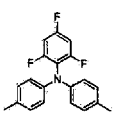 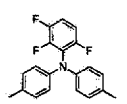 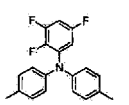 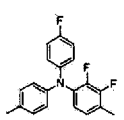 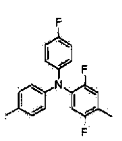 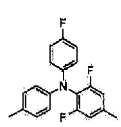

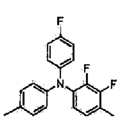 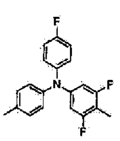

Moreover, structures in which the benzene rings in the above structural formulas are substituted with a substituent Ra are also included within the specific examples of the divalent aromatic amine structures $AA^F$. For example, in the above structural formulas, each benzene ring may independently have one or more of the aforementioned Ra groups.

<<Trivalent Aromatic Amine Structures $AA^F$>>

Examples of trivalent aromatic amine structures $AA^F$ include those shown below. Ar is as described above.

[Chemical formula 9]

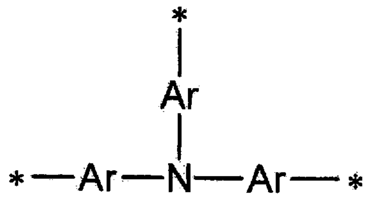

Specific examples include the following structures.

[Chemical formula 10]

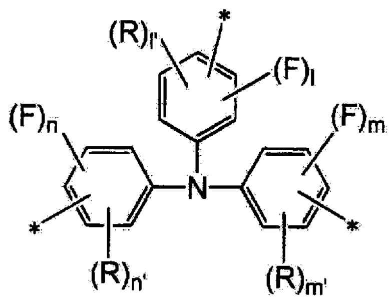

Each R independently represents a substituent Ra, and each of l, l', m, m', n and n' independently represents an integer of 0 to 4, provided that $l+m+n \geq 1$, $l+l' \leq 4$, $m+m' \leq 4$, and $n+n' \leq 4$.
More specific examples are shown below.

[Chemical formula 11]

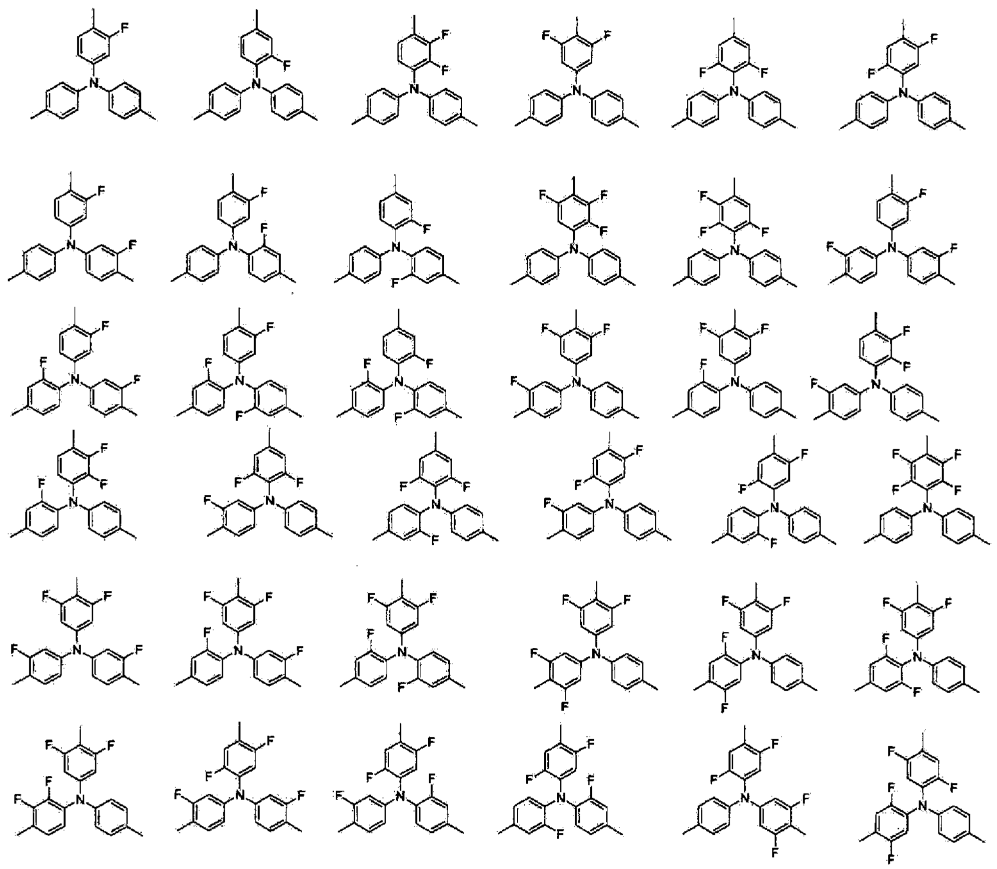

[Chemical formula 12]

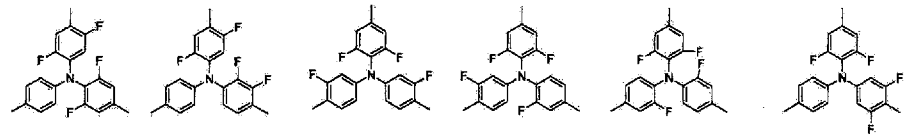
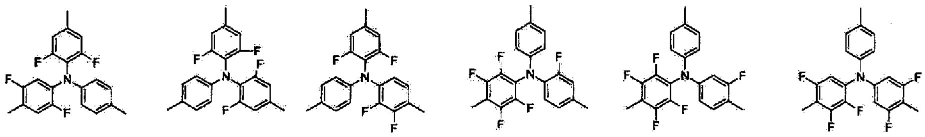
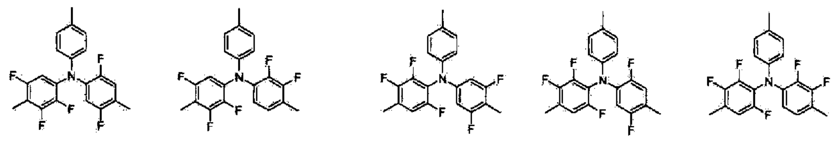
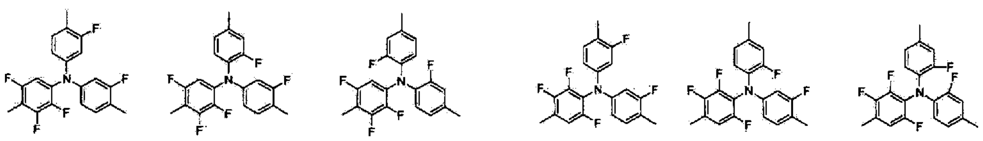
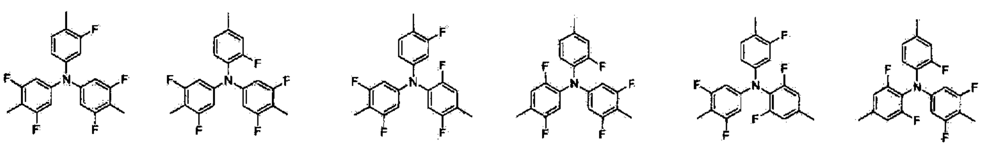
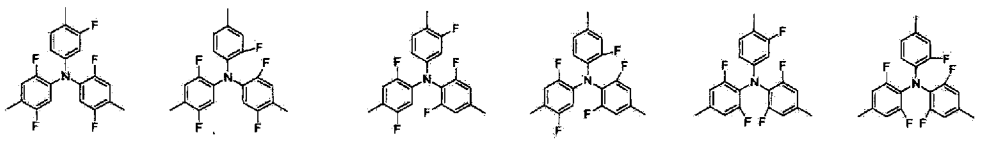
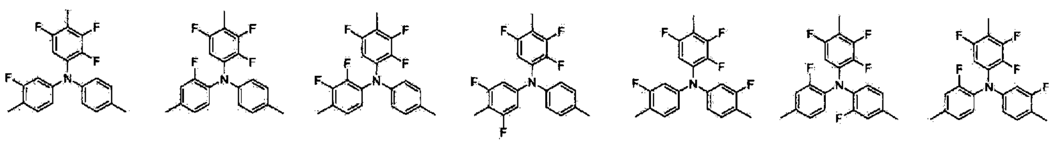
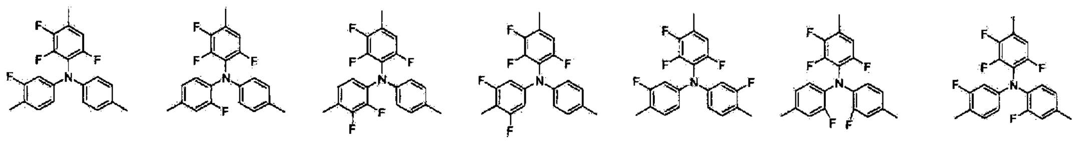
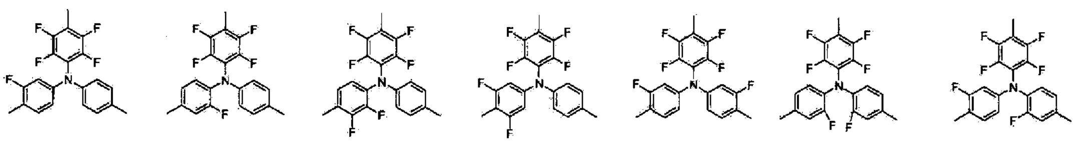
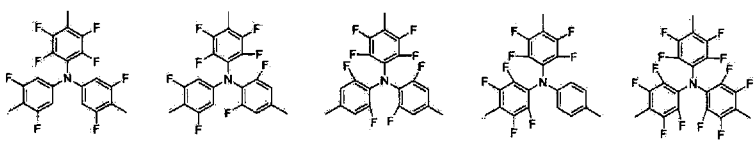

Moreover, structures in which the benzene rings in the above structural formulas are substituted with a substituent Ra are also included within the specific examples of the trivalent aromatic amine structures $AA^F$. For example, in the above structural formulas, each benzene ring may independently have one or more of the aforementioned Ra groups.

<<Monovalent Aromatic Amine Structures $AA^F$>>

Examples of monovalent aromatic amine structures $AA^F$ include those shown below. Ar is as described above.

[Chemical formula 13]

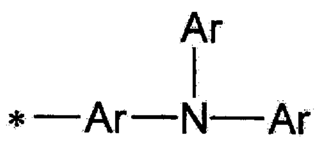

Specific examples include the following structures.

[Chemical formula 14]

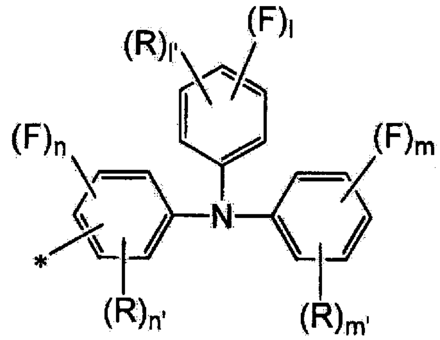

Each R independently represents a substituent Ra, each of l, l', m and m' independently represents an integer of 0 to 5, and each of n and n' independently represents an integer of 0 to 4, provided that $l+m+n \geq 1$, $l+l' \leq 5$, $m+m' \leq 5$, and $n+n' \leq 4$.

In the examples shown above, R is preferably an alkyl group, an aryl group or a heteroaryl group, and is more preferably an alkyl group or an aryl group. The alkyl group may be substituted with an aryl group, and the aryl group may be substituted with an alkyl group.

The value of l+m+n is preferably not more than 8, more preferably not more than 6, even more preferably not more than 4, and particularly preferably 3 or fewer.

The value of l'+m'+n' is preferably not more than 8, more preferably not more than 6, even more preferably not more than 4, and particularly preferably 3 or fewer.

The structural unit $AA^F$ contains either one, or two or more, of the aromatic amine structures $AA^F$, but preferably contains not more than 5, and more preferably 3 or fewer of these structures. When the structural unit $AA^F$ has two or more aromatic amine structures $AA^F$, the two or more aromatic amine structures $AA^F$ may be the same or different. The structural unit $AA^F$ has one or more bonding sites and is monovalent or higher, with the structural unit being mutually bonded to another structural unit at each of these bonding sites. From the viewpoint of improving the characteristics of organic electroluminescent elements, or from the viewpoint of enabling more favorable synthesis of the polymer or the like, the structural unit $AA^F$ is preferably hexavalent or lower, more preferably tetravalent or lower, and even more preferably divalent or trivalent.

Examples of the structural unit $AA^F$ are shown below. However, the structural unit $AA^F$ is not limited to the following structural units.

<<Divalent Structural Units $AA^F$>>

[Chemical formula 15]

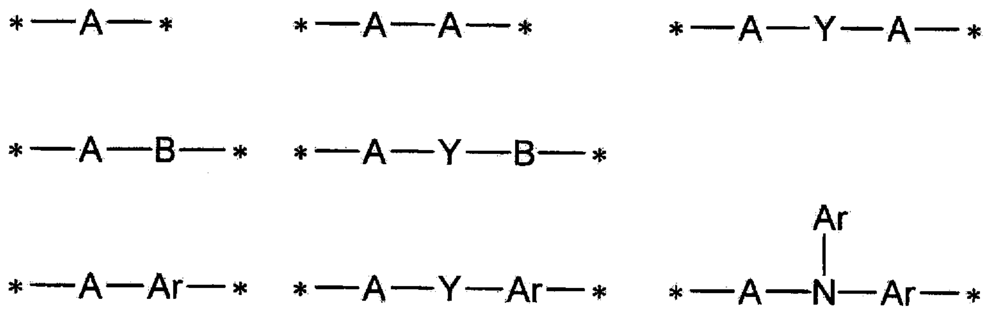

<<Trivalent or Tetravalent Structural Units $AA^F$>>

[Chemical formula 16]

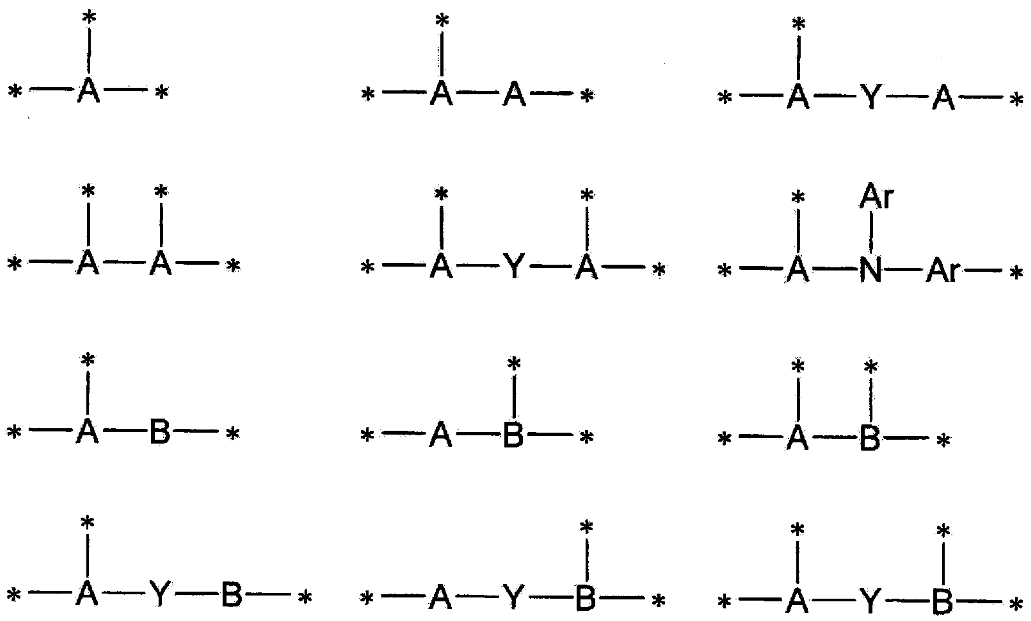

<<Monovalent Structural Units $AA^F$>>

[Chemical formula 17]

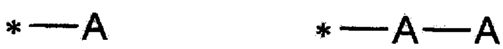

In the formulas, each "A" independently represents an aromatic amine structure $AA^F$, "B" represents a structure other than an aromatic amine structure $AA^F$, each "Ar" independently represents an aryl group (preferably of 6 to 30 carbon atoms), a heteroaryl group (preferably of 2 to 30 carbon atoms), an arylene group (preferably of 6 to 30 carbon atoms), or a heteroarylene group (preferably of 2 to 30 carbon atoms), and "Y" represents a divalent linking group. Ar may have a substituent, and examples of the substituent include the Rb group in a structural unit C2 described below. Examples of Y include divalent groups in which an additional hydrogen atom has been removed from those groups

having one or more hydrogen atoms among the groups listed for Rb in the structural unit C2 (but excluding groups containing a polymerizable functional group).

An arylene group is an atom grouping in which two hydrogen atoms have been removed from an aromatic hydrocarbon. A heteroarylene group is an atom grouping in which two hydrogen atoms have been removed from an aromatic heterocycle. The aromatic hydrocarbon and the aromatic heterocycle are as described above in relation to the aforementioned aryl group and heteroaryl group. References to arylene groups and heteroarylene groups in the following description have the same meaning.

(Structural Unit $CZ^F$)

The structural unit $CZ^F$ contains a carbazole structure having the aromatic hydrocarbon group $Ar^F$ bonded to the nitrogen atom (hereafter this carbazole structure is referred to as the "carbazole structure $CZ^F$").

A hydrogen atom may be bonded to the nitrogen atom contained within the carbazole structure (unsubstituted), or a monovalent organic group or a divalent or higher organic group may be bonded to the nitrogen atom. Examples of the monovalent organic group include a monovalent aromatic hydrocarbon group and a monovalent aliphatic hydrocarbon group. Further, examples of the divalent or higher organic groups include a divalent or higher aromatic hydrocarbon group and a divalent or higher aliphatic hydrocarbon group. Here, the "aromatic hydrocarbon" is the same as the "aromatic hydrocarbon" of the aforementioned aromatic amine structure. The aromatic hydrocarbon group may have a substituent.

Examples of the "aliphatic hydrocarbon" include saturated aliphatic hydrocarbons and unsaturated aliphatic hydrocarbons. The number of carbon atoms in the aliphatic hydrocarbon group is preferably from 1 to 22, more preferably from 1 to 12, even more preferably from 1 to 8, and particularly preferably from 1 to 6. Examples of monovalent saturated aliphatic hydrocarbon groups include alkyl groups, and specific examples include the same groups as those listed as examples for the "alkyl group" described above. Examples of monovalent unsaturated aliphatic hydrocarbon groups include alkenyl groups and alkynyl groups. Specific examples of the alkenyl groups include a vinyl group and an allyl group, whereas examples of the alkynyl groups include an ethynyl group and a propargyl group. Examples of divalent saturated aliphatic hydrocarbon groups include alkylene groups, whereas examples of divalent unsaturated aliphatic hydrocarbon groups include alkenylene groups and alkynylene groups. The aliphatic hydrocarbon group may have a substituent.

The number of fluorine atoms bonded to the two benzene rings contained in the carbazole structure and the aromatic hydrocarbon group bonded to the nitrogen atom may be either 0, or 1 or greater. When the benzene rings or the aromatic hydrocarbon group bonded to the nitrogen atom are substituted with a fluorine atom, these become an aromatic hydrocarbon group $Ar^F$.

The carbazole structure $CZ^F$ has one or more of the aromatic hydrocarbon groups $Ar^F$. The upper limit for the number of fluorine atoms within a single aromatic hydrocarbon group $Ar^F$ is determined by the structure of the aromatic hydrocarbon group $Ar^F$, and for example is not more than 5 when the aromatic hydrocarbon group $Ar^F$ is a benzene structure, or not more than 7 in the case of a naphthalene structure. There are no particular limitations on the substitution position(s) of the fluorine atom(s). In those cases where the aromatic hydrocarbon group $Ar^F$ is substituted with one or two fluorine atoms at the ortho position(s) relative to the bonding site with another structure, the lowering effect on the HOMO level, or the increase effect on the $S_1$ energy and/or $T_1$ energy tends to be more readily obtained.

The number of fluorine atoms contained in the carbazole structure $CZ^F$ is at least one. Further, from the viewpoint of improving the characteristics of the organic electronic element, the upper limit for the number of fluorine atoms is preferably not more than 8, more preferably not more than 6, and even more preferably not more than 4. In particular, when the number of fluorine atoms is 3 or fewer, the lowering effect on the HOMO level, or the increase effect on the $S_1$ energy and/or $T_1$ energy tends to be more readily obtained.

In one embodiment, considering the effect of substituent groups, the carbazole structure $CZ^F$ may have no substituents other than the fluorine atom(s). Further, in another embodiment, from the viewpoint of imparting desired functionality to the charge transport polymer I, the carbazole structure $CZ^F$ may also have a substituent other than a fluorine atom (a substituent Ra). Furthermore, the aliphatic hydrocarbon group bonded to the nitrogen atom may have a substituent, and examples of the substituent include the substituents Rb described below.

In a similar manner to the aromatic amine structure $AA^F$, the aromatic hydrocarbon group in the carbazole structure $CZ^F$ may have an alkyl group of 1 to 12 carbon atoms, for example in order to impart improved solubility in organic solvents. Further, in order to lower the HOMO level or increase the $S_1$ energy and/or $T_1$ energy, the aromatic hydrocarbon group in the carbazole structure $CZ^F$ may have an alkyl group of 1 to 6 carbon atoms at the ortho position relative to the bonding site with another structure. Examples of preferred alkyl groups for either of these configurations include the same groups as those listed above in relation to the aromatic amine structure $AA^F$.

In those cases where the carbazole structure $CZ^F$ has the aromatic hydrocarbon group $Ar^F$ and an aromatic hydrocarbon group that is not substituted with a fluorine atom (wherein the "aromatic hydrocarbon group" includes the two benzene rings and the aromatic hydrocarbon group bonded to the nitrogen atom), a substituent other than a fluorine

atom may exist within the aromatic hydrocarbon group $Ar^F$, or may exist within the aromatic hydrocarbon group that is not substituted with a fluorine atom. In either case, the number of these substituents Ra included within a single aromatic hydrocarbon group may be 0, or 1 or greater, and is preferably 0 or 1. From the viewpoint of improving the characteristics of the organic electronic element, the upper limit for the number of substituents Ra contained within the carbazole structure $CZ^F$ is preferably not more than 8, more preferably not more than 6, even more preferably not more than 4, and particularly preferably 3 or fewer.

The carbazole structure $CZ^F$ has one or more bonding sites and is monovalent or higher, with the structure being mutually bonded to another structure at each of these bonding sites. From the viewpoint of improving the characteristics of organic electroluminescent elements, or from the viewpoint of enabling more favorable synthesis of the polymer or the like, the carbazole structure $CZ^F$ is preferably hexavalent or lower, more preferably tetravalent or lower, and even more preferably divalent or trivalent.

Examples of the carbazole structure $CZ^F$ include the structures shown below. However, the carbazole structure $CZ^F$ is not limited to the following structures.

<<Divalent Carbazole Structures $CZ^F$>>

Examples of divalent carbazole structures $CZ^F$ include those shown below.

[Chemical formula 18]

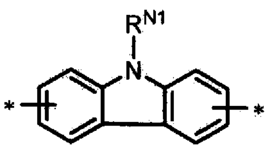

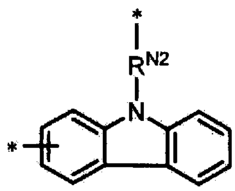

$R^{N1}$ represents a hydrogen atom, a monovalent aromatic hydrocarbon group or a monovalent aliphatic hydrocarbon group, and at least one of the two benzene rings or $R^{N1}$ (provided $R^{N1}$ is a monovalent aromatic hydrocarbon group) is the aromatic hydrocarbon group $Ar^F$. Each of the two benzene rings and the monovalent aromatic hydrocarbon group may independently have a substituent Ra, and the monovalent aliphatic hydrocarbon group may have a substituent Rb.

$R^{N2}$ represents a divalent aromatic hydrocarbon group or a divalent aliphatic hydrocarbon group, and at least one of the two benzene rings or $R^{N2}$ (provided $R^{N2}$ is a divalent aromatic hydrocarbon group) is the aromatic hydrocarbon group $Ar^F$. Each of the two benzene rings and the divalent aromatic hydrocarbon group may independently have a substituent Ra, and the divalent aliphatic hydrocarbon group may have a substituent Rb.

Specific examples include the structures shown below.

[Chemical formula 19]

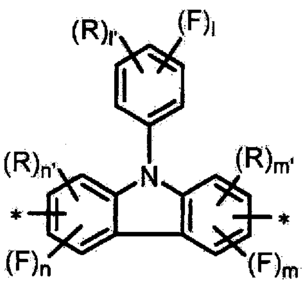

Each R independently represents a substituent Ra, each of l and l' independently represents an integer of 0 to 5, and each of m, m', n and n' independently represents an integer of 0 to 3, provided that $l+m+n \geq 1$, $l+l' \leq 5$, $m+m' \leq 3$, and $n+n' \leq 3$.

[Chemical formula 20]

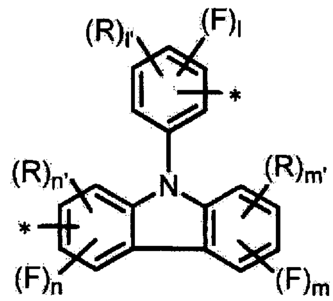

Each R independently represents a substituent Ra, each of l, l', m and m' independently represents an integer of 0 to 4, and each of n and n' independently represents an integer of 0 to 3, provided that $l+m+n \geq 1$, $l+l' \leq 4$, $m+m' \leq 4$, and $n+n' \leq 3$.

More specific examples are shown below.

[Chemical formula 21]

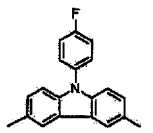 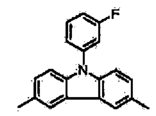 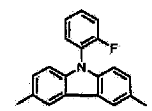 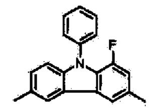 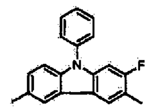 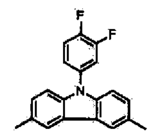

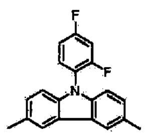 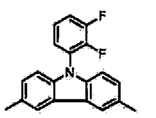 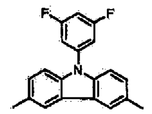 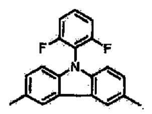 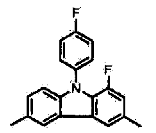 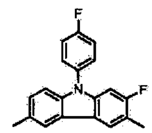

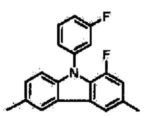 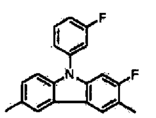 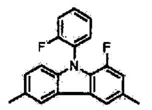 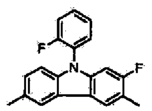 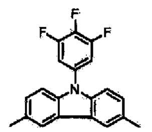 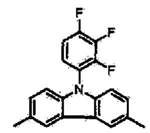

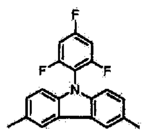 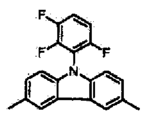 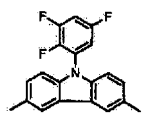 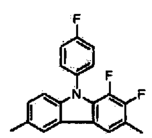 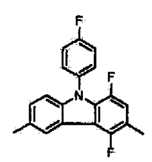 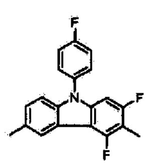

Moreover, structures in which the benzene rings in the above structural formulas are substituted with a substituent Ra are also included within the specific examples of divalent carbazole structures $CZ^F$. For example, in the above structural formulas, each of the three benzene rings may independently have one or more of the aforementioned Ra groups.

<<Trivalent or Tetravalent Carbazole Structures $CZ^F$>>

Examples of trivalent and tetravalent carbazole structures $CZ^F$ include those shown below.

[Chemical formula 22]

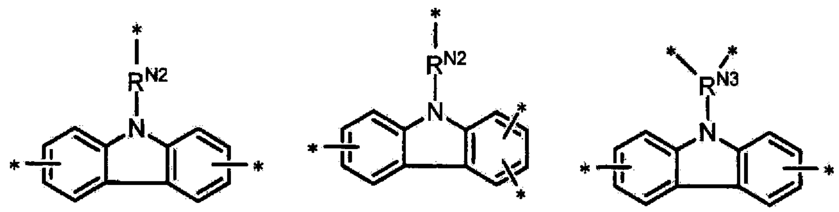

$R^{N2}$ and the benzene rings are as described above.

$R^{N3}$ represents a trivalent aromatic hydrocarbon group or a trivalent aliphatic hydrocarbon group, and at least one of the two benzene rings or $R^{N3}$ (provided $R^{N3}$ is a trivalent aromatic hydrocarbon group) is the aromatic hydrocarbon group $Ar^F$. Each of the two benzene rings and the trivalent aromatic hydrocarbon group may independently have a substituent Ra, and the trivalent aliphatic hydrocarbon group may have a substituent Rb.

Specific examples include the structures shown below.

[Chemical formula 23]

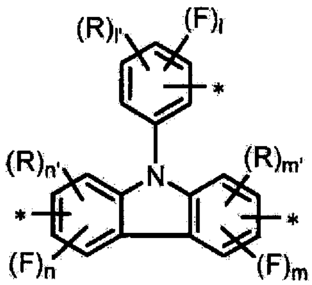

Each R independently represents a substituent Ra, each of l and l' independently represents an integer of 0 to 4, and each of m, m', n and n' independently represents an integer of 0 to 3, provided that $l+m+n \geq 1$, $l+l' \leq 4$, $m+m' \leq 3$, and $n+n' \leq 3$.

[Chemical formula 24]

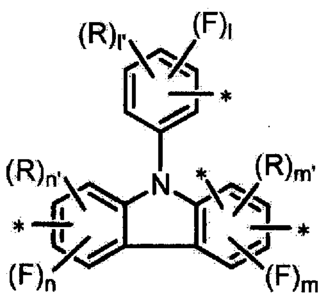

Each R independently represents a substituent Ra, each of l and l' independently represents an integer of 0 to 4, each of m and m' independently represents an integer of 0 to 2, and each of n and n' independently represents an integer of 0 to 3, provided that $l+m+n \geq 1$, $l+l' \leq 4$, $m+m' \leq 3$, and $n+n' \leq 2$.

[Chemical formula 25]

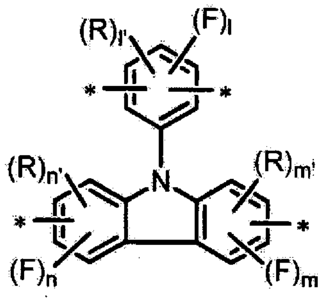

Each R independently represents a substituent Ra, and each of l, l', m, m', n and n' independently represents an integer of 0 to 3, provided that $l+m+n \geq 1$, $l+l' \leq 3$, $m+m' \leq 3$, and $n+n' \leq 3$.

More specific examples are shown below.

[Chemical formula 26]

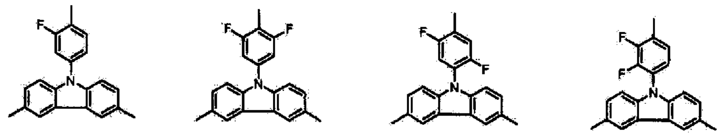

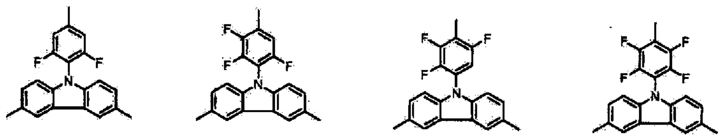

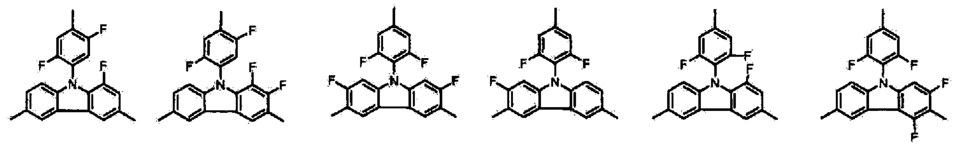

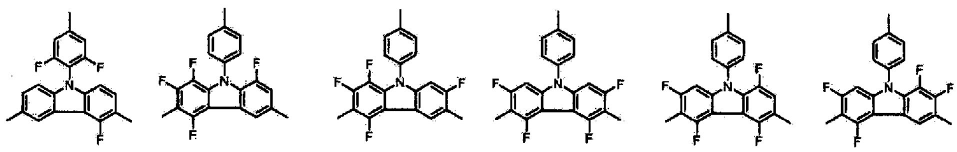

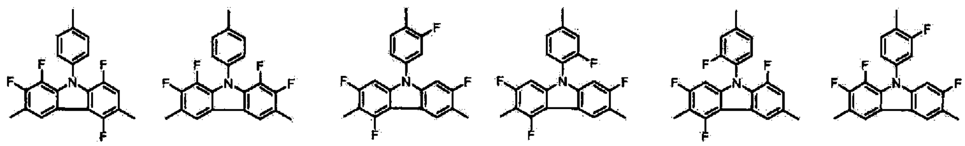

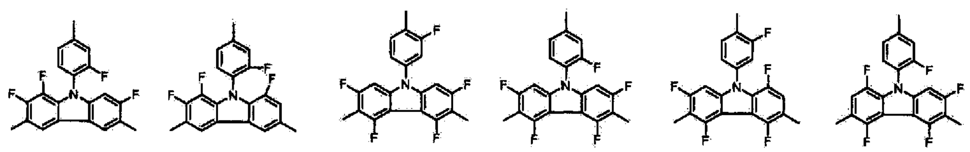

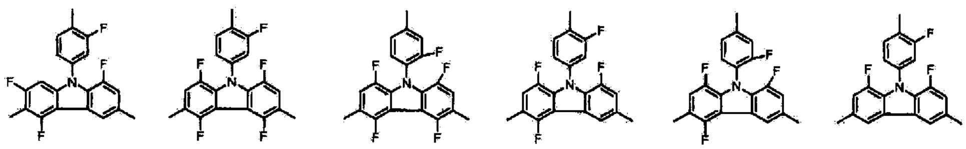

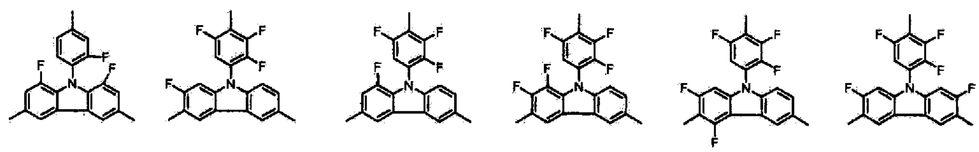

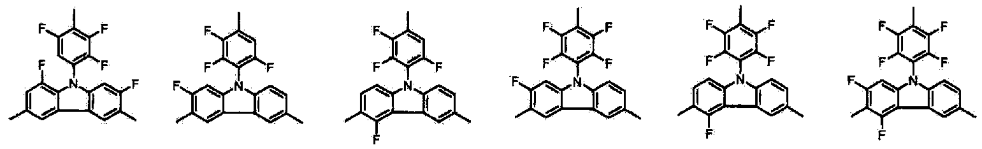

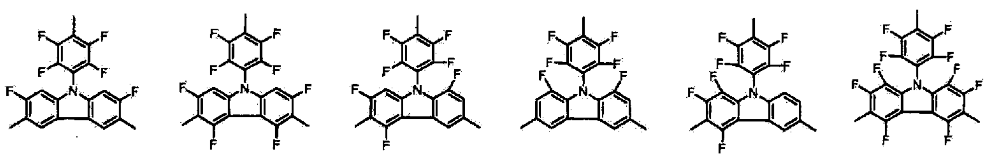

Moreover, structures in which the benzene rings in the above structural formulas are substituted with a substituent Ra are also included within the specific examples of trivalent carbazole structures $CZ^F$. For example, in the above structural formulas, each of the three benzene rings may independently have one or more of the aforementioned Ra groups.

<<Monovalent Carbazole Structures $CZ^F$>>

Examples of monovalent carbazole structures $CZ^F$ include those shown below. $R^{N1}$, $R^{N2}$ and the benzene rings are as described above.

[Chemical formula 27]

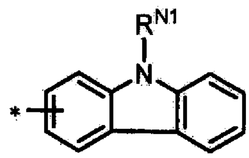

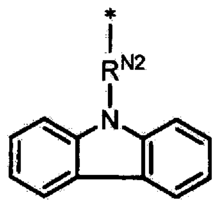

Specific examples include the structures shown below.

[Chemical formula 28]

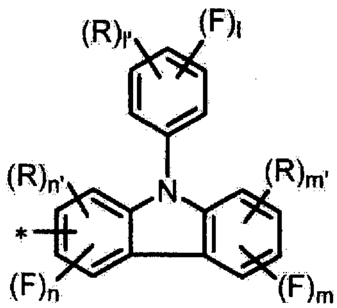

Each R independently represents a substituent Ra, each of l and l' independently represents an integer of 0 to 5, each of m and m' independently represents an integer of 0 to 4, and each of n and n' independently represents an integer of 0 to 3, provided that $l+m+n \geq 1$, $l+l' \leq 5$, $m+m' \leq 4$, and $n+n' \leq 3$.

[Chemical formula 29]

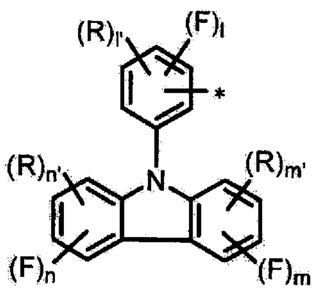

Each R independently represents a substituent Ra, and each of l, l', m, m', n and n' independently represents an integer of 0 to 4, provided that $l+m+n \geq 1$, $l+l' \leq 4$, $m+m' \leq 4$, and $n+n' \leq 4$.

In the examples described above, $R^{N1}$ is preferably a substituted or unsubstituted "phenyl group or naphthyl group", and is more preferably a substituted or unsubstituted phenyl group. $R^{N2}$ is preferably a substituted or unsubstituted "phenylene group or naphthylene group", and is more preferably a substituted or unsubstituted phenylene group. The phenylene group may be a 1,2-phenylene group or 1,3-phenylene group, 1,4-phenylene group, and is preferably a 1,4-phenylene group. $R^{N3}$ is preferably a substituted or unsubstituted "benzene-triyl group or naphthalene-triyl group", and is more preferably a substituted or unsubstituted benzene-triyl group. The benzene-triyl group is preferably a 1,3,5-benzene-triyl group.

R is preferably an alkyl group, an aryl group or a heteroaryl group, and is more preferably an alkyl group or an aryl group. The alkyl group may be substituted with an aryl group, and the aryl group may be substituted with an alkyl group.

Further, l+m+n is preferably not more than 8, more preferably not more than 6, even more preferably not more than 4, and particularly preferably 3 or less.

Furthermore, l'+m'+n' is preferably not more than 8, more preferably not more than 6, even more preferably not more than 4, and particularly preferably 3 or less.

The structural unit $CZ^F$ contains either one, or two or more, of the carbazole structures $CZ^F$, but preferably contains not more than 5, and more preferably 3 or fewer of these structures. When the structural unit $CZ^F$ has two or more carbazole structures $CZ^F$, the two or more carbazole structures $CZ^F$ may be the same or different. The structural unit $CZ^F$ has one or more bonding sites and is monovalent or higher, with the structural unit being mutually bonded to another structural unit at each of these bonding sites. From the viewpoint of improving the characteristics of organic electroluminescent elements, or from the viewpoint of enabling more favorable synthesis of the polymer or the like, the structural unit $CZ^F$ is preferably hexavalent or lower, more preferably tetravalent or lower, and even more preferably divalent or trivalent.

Examples of the structural unit $CZ^F$ are shown below. However, the structural unit $CZ^F$ is not limited to the following structural units.

<<Divalent Structural Units $CZ^F$>>

[Chemical formula 30]

*—A—*　　*—A—A—*　　*—A—Y—A—*

*—A—B—*　　*—A—Y—B—*

*—A—Ar—*　　*—A—Y—Ar—*

<<Trivalent or Tetravalent Structural Units $CZ^F$>>

[Chemical formula 31]

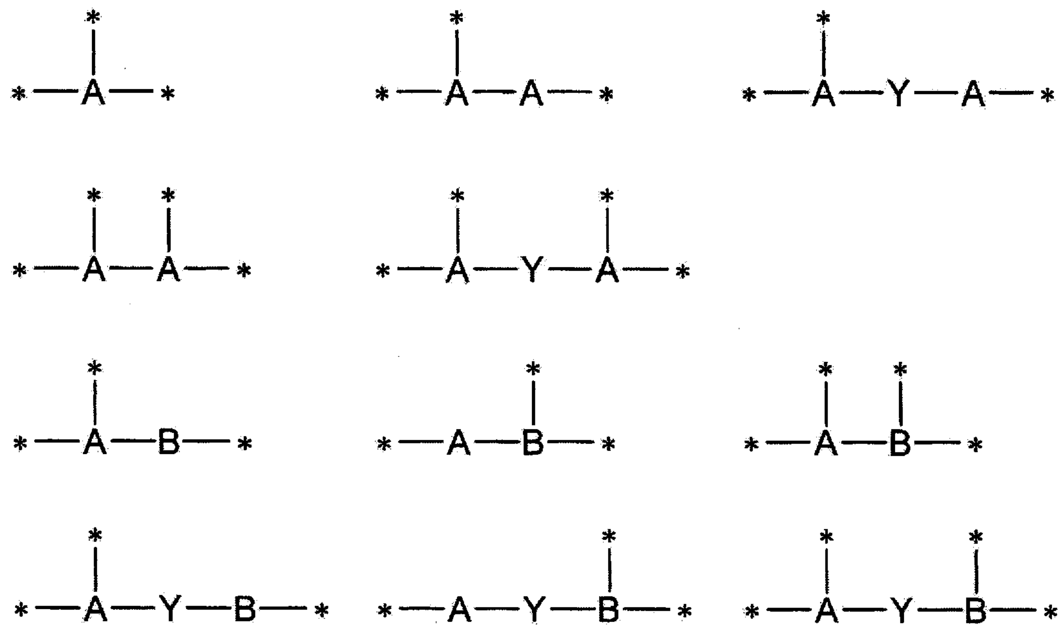

<<Monovalent Structural Units $CZ^F$>>

[Chemical formula 32]

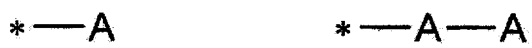

In the above formulas, each "A" independently represents a carbazole structure $CZ^F$, "B" represents a structure other than a carbazole structure $CZ^F$, each "Ar" independently represents an arylene group (preferably of 6 to 30 carbon atoms) or a heteroarylene group (preferably of 2 to 30 carbon atoms), and "Y" represents a divalent linking group. Ar may have a substituent, and examples of the substituent include the Rb group in a structural unit C2 described below. Examples of Y include divalent groups in which an additional hydrogen atom has been removed from those groups having one or more hydrogen atoms among the groups listed for Rb in the structural unit C2 (but excluding groups containing a polymerizable functional group).

(Structural Unit CZ)

The structural unit CZ contains a carbazole structure that does not have an aromatic hydrocarbon group $Ar^F$ bonded to the nitrogen atom (hereafter this carbazole structure is also referred to as a "carbazole structure CZ").

The carbazole structure CZ is a carbazole structure in which none of the hydrogen atoms bonded to an $sp^2$ carbon, contained within either the two benzene rings or the aromatic hydrocarbon group in those cases where an aromatic hydrocarbon group is bonded to the nitrogen atom, has been substituted with a fluorine atom. With the exception of having no hydrogen atoms bonded to $sp^2$ carbons substituted with a fluorine atom, the carbazole structure CZ may have the same structure as that described above in relation to the carbazole structure $CZ^F$.

Examples of the carbazole structure CZ include the structures shown below. However, the carbazole structure CZ is not limited to the following structures.

<<Divalent Carbazole Structures CZ>>

Examples of divalent carbazole structures CZ include those shown below.

[Chemical formula 33]

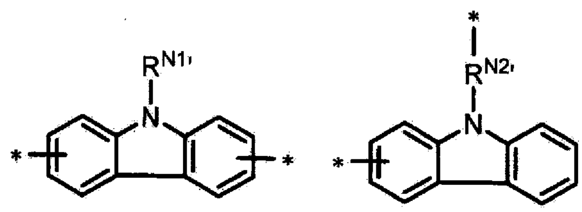

$R^{N1'}$ represents a hydrogen atom, a monovalent aromatic hydrocarbon group or a monovalent aliphatic hydrocarbon group. Each of the two benzene rings and the monovalent aromatic hydrocarbon group may independently have a substituent Ra, and the monovalent aliphatic hydrocarbon group may have a substituent Rb.

$R^{N2'}$ represents a divalent aromatic hydrocarbon group or a divalent aliphatic hydrocarbon group. Each of the two benzene rings and the divalent aromatic hydrocarbon group may independently have a substituent Ra, and the divalent aliphatic hydrocarbon group may have a substituent Rb.

Specific examples include the structures shown below.

[Chemical formula 34]

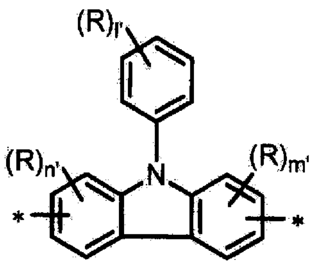

Each R independently represents a substituent Ra, l' represents an integer of 0 to 5, and each of m' and n' independently represents an integer of 0 to 3.

[Chemical formula 35]

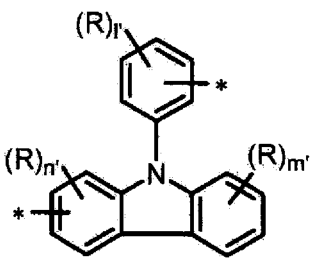

Each R independently represents a substituent Ra, each of l' and m' represents an integer of 0 to 4, and n' represents an integer of 0 to 3.

<<Trivalent or Tetravalent Carbazole Structures CZ>>

Examples of trivalent and tetravalent carbazole structures CZ include those shown below.

[Chemical formula 36]

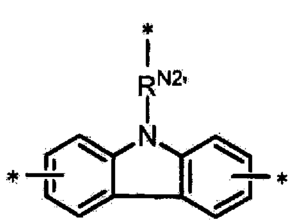 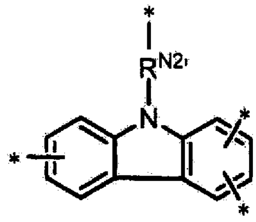 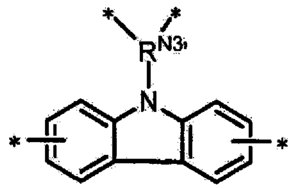

$R^{N2'}$ and the benzene rings are as described above.

$R^{N3'}$ represents a trivalent aromatic hydrocarbon group or a trivalent aliphatic hydrocarbon group. Each of the two benzene rings and the trivalent aromatic hydrocarbon group may independently have a substituent Ra, and the trivalent aliphatic hydrocarbon group may have a substituent Rb.

Specific examples include the structures shown below.

[Chemical formula 37]

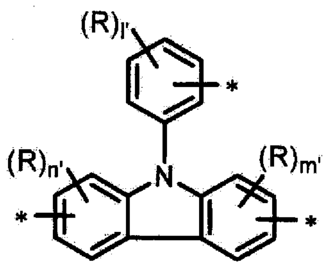

Each R independently represents a substituent Ra, l' represents an integer of 0 to 4, and each of m' and n' independently represents an integer of 0 to 3.

[Chemical formula 38]

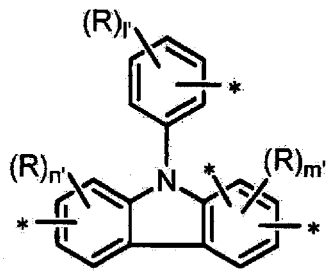

Each R independently represents a substituent Ra, l' represents an integer of 0 to 4, m' represents an integer of 0 to 2, and n' represents an integer of 0 to 3.

[Chemical formula 39]

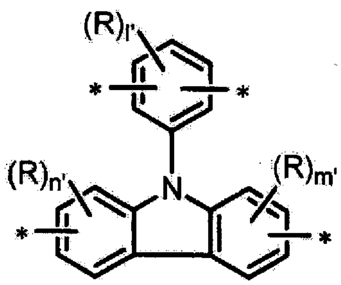

Each R independently represents a substituent Ra, and each of l', m' and n' independently represents an integer of 0 to 3.

<<Monovalent Carbazole Structures CZ>>

Examples of monovalent carbazole structures CZ include those shown below. $R^{N1'}$, $R^{N2'}$ and the benzene rings are as described above.

[Chemical formula 40]

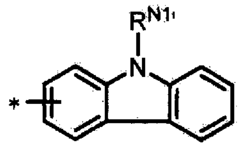
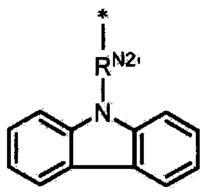

Specific examples include the structures shown below.

[Chemical formula 41]

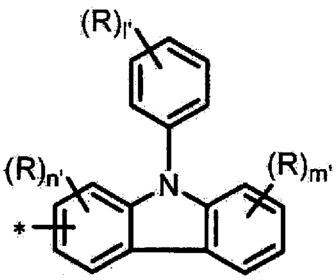

Each R independently represents a substituent Ra, l' represents an integer of 0 to 5, m' represents an integer of 0 to 4, and n' represents an integer of 0 to 3.

[Chemical formula 42]

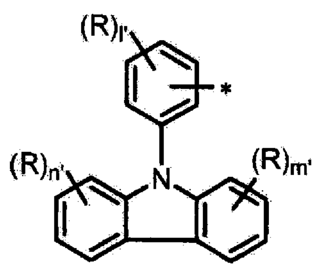

Each R independently represents a substituent Ra, and each of l', m' and n' independently represents an integer of 0 to 4.

In the examples described above, $R^{N1'}$ is preferably a substituted or unsubstituted "phenyl group or naphthyl group", and is more preferably a substituted or unsubstituted phenyl group. $R^{N2'}$ is preferably a substituted or unsubstituted "phenylene group or naphthylene group", and is more preferably a substituted or unsubstituted phenylene group. The phenylene group may be a 1,2-phenylene group, 1,3-phenylene group or 1,4-phenylene group, and is preferably a 1,4-phenylene group. $R^{N3'}$ is preferably a substituted or unsubstituted "benzene-triyl group or naphthalene-triyl group", and is more preferably a substituted or unsubstituted benzene-triyl group. The benzene-triyl group is preferably a 1,3,5-benzene-triyl group.

R is preferably an alkyl group, an aryl group or a heteroaryl group, and is more preferably an alkyl group or an

aryl group. The alkyl group may be substituted with an aryl group, and the aryl group may be substituted with an alkyl group.

Further, l'+m'+n' is preferably not more than 8, more preferably not more than 6, even more preferably not more than 4, and particularly preferably 3 or less.

The structural unit CZ contains either one, or two or more, of the carbazole structures CZ, but preferably contains not more than 5, and more preferably 3 or fewer of these structures. When the structural unit CZ has two or more carbazole structures CZ, the two or carbazole structures CZ may be the same or different. The structural unit CZ has one or more bonding sites and is monovalent or higher, with the structural unit being mutually bonded to another structural unit at each of these bonding sites. From the viewpoint of improving the characteristics of organic electroluminescent elements, or from the viewpoint of enabling more favorable synthesis of the polymer or the like, the carbazole structure CZ is preferably hexavalent or lower, more preferably tetravalent or lower, and even more preferably divalent or trivalent.

Examples of the structural unit CZ are shown below. However, the structural unit CZ is not limited to the following structural units.

<<Divalent Structural Units CZ>>

[Chemical formula 43]

*—B—*     *—B—B—*     *—B—Y—B—*

*—B—Ar—*     *—B—Y—Ar—*

<<Trivalent or Tetravalent Structural Units CZ>>

[Chemical formula 44]

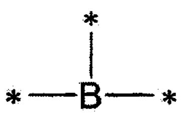
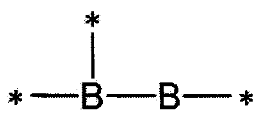
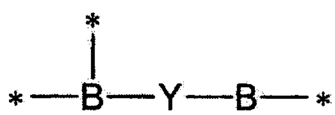
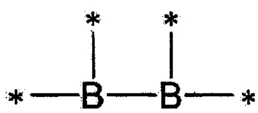
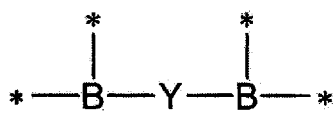

<<Monovalent Structural Units CZ>>

[Chemical formula 45]

*—B     *—B—B

In the above formulas, each "B" independently represents a carbazole structure CZ or an optional structural unit described below, provided that at least one "B" within each structural unit is a carbazole structure CZ. Each "Ar" independently represents an arylene group (preferably of 6 to 30 carbon atoms) or a heteroarylene group (preferably of 2 to 30 carbon atoms), and "Y" represents a divalent linking group. Ar may have a substituent, and examples of the substituent include the Rb group in a structural unit C2 described below. Examples of Y include divalent groups in which an additional hydrogen atom has been removed from those groups having one or more hydrogen atoms among the

groups listed for Rb in the structural unit C2 (but excluding groups containing a polymerizable functional group).

(Structural Unit AA)

Examples of other optional structural units that the charge transport polymer I may have include a structural unit AA. The structural unit AA is a structural unit which contains an aromatic amine structure that does not have an aromatic hydrocarbon group $Ar^F$ (hereafter, this "aromatic amine structure that does not have an aromatic hydrocarbon group $Ar^F$" is referred to as an "aromatic amine structure AA").

The aromatic amine structure AA is an aromatic amine structure that is not substituted with a fluorine atom. With the exception of not being substituted with a fluorine atom, the aromatic amine structure AA may have the same structure as that described above for the aromatic amine structure AA.

Examples of the aromatic amine structure AA are shown below. However, the aromatic amine structure AA is not limited to the following structural units.

<<Divalent Aromatic Amine Structures AA>>

Examples of divalent aromatic amine structures AA are shown below.

[Chemical formula 46]

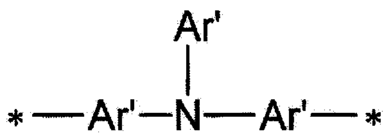

Each Ar' independently represents an aromatic hydrocarbon group. Each Ar' may be independently substituted with a substituent Ra.

Specific examples include the structures shown below.

[Chemical formula 47]

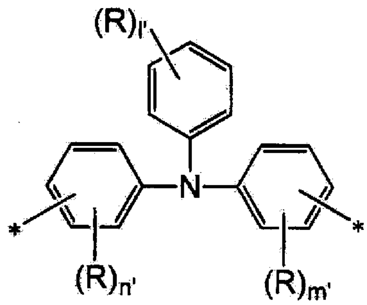

Each R independently represents a substituent Ra, l' represents an integer of 0 to 5, and each of m' and n' independently represents an integer of 0 to 4.

<<Trivalent Aromatic Amine Structures AA>>

Examples of trivalent aromatic amine structures AA are shown below. Ar' is as described above.

[Chemical formula 48]

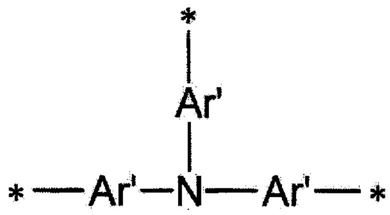

Specific examples include the structures shown below.

[Chemical formula 49]

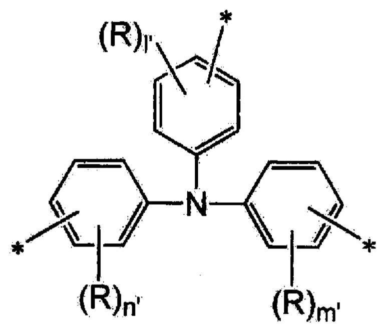

Each R independently represents a substituent Ra, and each of l', m' and n' independently represents an integer of 0 to 4.

<<Monovalent Aromatic Amine Structures AA>>

Examples of monovalent aromatic amine structures AA are shown below. Ar' is as described above.

[Chemical formula 50]

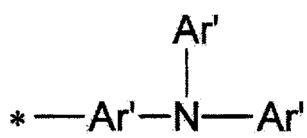

Specific examples include the structures shown below.

[Chemical formula 51]

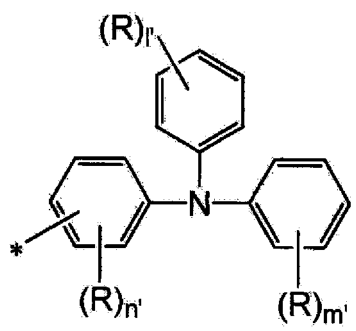

Each R independently represents a substituent Ra, each of l' and m' independently represents an integer of 0 to 5, and n' represents an integer of 0 to 4.

In the examples described above, R is preferably an alkyl group, an aryl group or a heteroaryl group, and is more preferably an alkyl group or an aryl group. The alkyl group may be substituted with an aryl group, and the aryl group may be substituted with an alkyl group.

Further, l'+m'+n' is preferably not more than 8, more preferably not more than 6, even more preferably not more than 4, and particularly preferably 3 or less.

The structural unit AA contains either one, or two or more, of the aromatic amine structures AA, but preferably contains not more than 5, and more preferably 3 or fewer of these structures. When the structural unit AA has two or more aromatic amine structures AA, the two or more aromatic amine structures AA may be the same or different. The structural unit AA has one or more bonding sites and is monovalent or higher, with the structural unit being mutually bonded to another structural unit at each of these bonding sites. From the viewpoint of improving the characteristics of organic electroluminescent elements, or from the viewpoint of enabling more favorable synthesis of the polymer or the like, the aromatic amine structure AA is preferably hexavalent or lower, more preferably tetravalent or lower, and even more preferably divalent or trivalent.

Examples of the structural unit AA are shown below. However, the structural unit AA is not limited to the following structural units.

<<Divalent Structural Units AA>>

[Chemical formula 52]

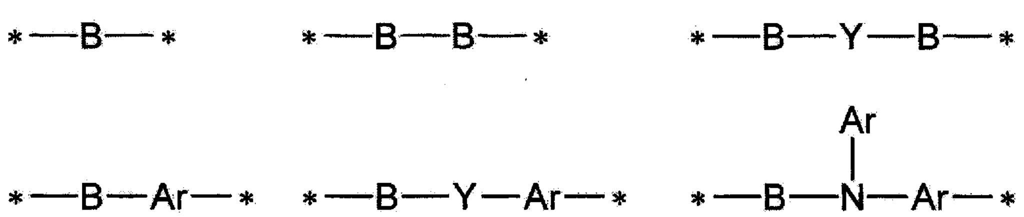

<<Trivalent or Tetravalent Structural Units AA>>

[Chemical formula 53]

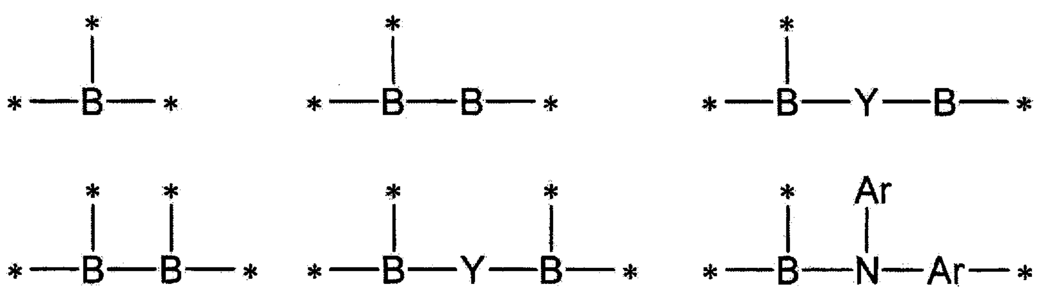

<<Monovalent Structural Units AA>>

[Chemical formula 54]

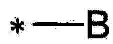

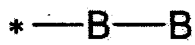

In the above formulas, each "B" independently represents an aromatic amine structure AA or an optional structural unit described below, provided that at least one "B" within each structural unit is an aromatic amine structure AA. Each "Ar" independently represents an aryl group (preferably of 6 to 30 carbon atoms), a heteroaryl group (preferably of 2 to 30 carbon atoms), an arylene group (preferably of 6 to 30 carbon atoms) or a heteroarylene group (preferably of 2 to 30 carbon atoms), and "Y" represents a divalent linking group. Ar may have a substituent, and examples of the substituent include the Ra group (substituents other than a fluorine atom). Examples of Y include divalent groups in which an additional hydrogen atom has been removed from those groups having one or more hydrogen atoms among the groups listed for Rb in the structural unit C2 (but excluding groups containing a polymerizable functional group).

(Structural Unit C)

Other examples of optional structural units that the charge transport polymer I may have include a structural unit C. The structural unit C is a structural unit that differs from the structural units described above. The structural unit C has one or more bonding sites and is monovalent or higher, with the structural unit being mutually bonded to another structural unit at each of these bonding sites. The structural unit C includes divalent structural units C2, trivalent or higher structural units C3, and monovalent structural units C1.

<<Structural Unit C2>>

The structural unit C2 is a divalent structural unit. The structural unit C2 preferably includes an atom grouping having the ability to transport an electric charge. For example, the structural unit C2 may be selected from among thiophene structures, fluorene structures, benzene structures, biphenyl structures, terphenyl structures, naphthalene structures, anthracene structures, tetracene structures, phenanthrene structures, dihydrophenanthrene structures, pyridine structures, pyrazine structures, quinoline structures, isoquinoline structures, quinoxaline structures, acridine structures, diazaphenanthrene structures, furan structures, pyrrole structures, oxazole structures, oxadiazole structures, thiazole structures, thiadiazole structures, triazole structures, benzothiophene structures, benzoxazole structures, benzoxadiazole structures, benzothiazole structures, benzothiadiazole structures, and benzotriazole structures, which may be substituted or unsubstituted, and structures containing one type, or two or more types, of the above structures. When the structural unit C2 contains two or more of the above structures, the two or more structures may be the same or different.

In one embodiment, from the viewpoint of obtaining superior hole transport properties, the structural unit C2 is preferably selected from among substituted or unsubstituted thiophene structures, fluorene structures, benzene structures, and pyrrole structures, and structures containing one type, or two or more types, of these structures. In another embodiment, from the viewpoint of obtaining superior electron transport properties, the structural unit C2 is preferably selected from among substituted or unsubstituted fluorene structures, benzene structures, phenanthrene structures, pyridine structures, and quinoline structures, and structures containing one type, or two or more types, of these structures.

Specific examples of the structural unit C2 are shown below. However, the structural unit C2 is not limited to the following structures.

[Chemical formula 55]

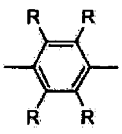 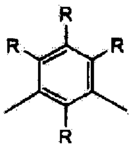 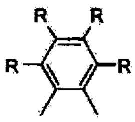 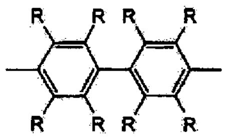 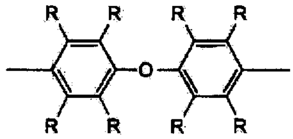

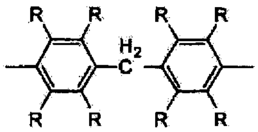 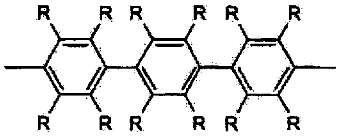 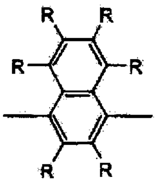 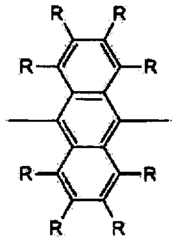

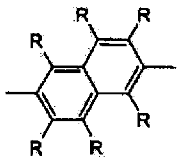 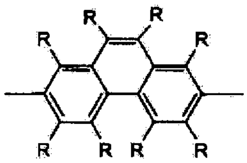 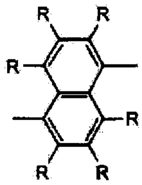

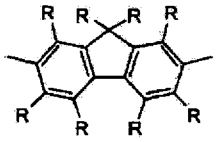 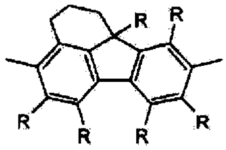 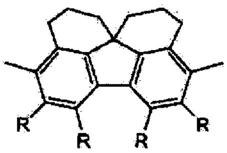

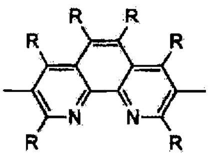 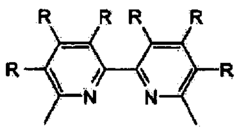 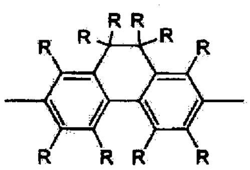 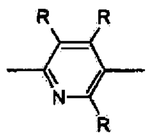

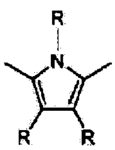 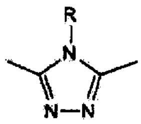 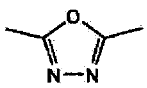 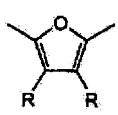 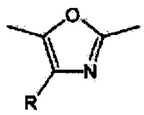

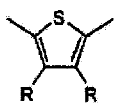 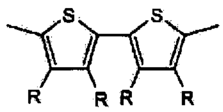 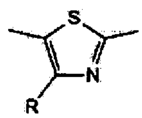 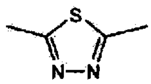

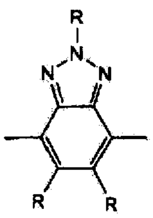 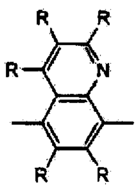 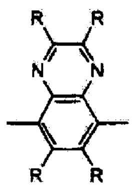 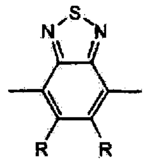 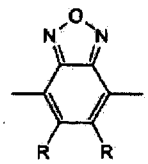 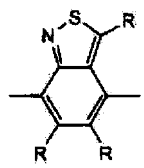

Each R independently represents a hydrogen atom or a substituent Rb. It is preferable that each Rb is independently selected from a group consisting of $-R^1$ (but excluding the case of a hydrogen atom), $-OR^2$, $-SR^3$, $-OCOR^4$, $-COOR^5$, $-SiR^6R^7R^8$, -CN, $-NO_2$, halogen atoms (such as -F,-Cl or -Br), and groups containing a polymerizable functional group described below. Each of $R^1$ to $R^8$ independently represents a hydrogen atom; a linear, cyclic or branched alkyl group (preferably of 1 to 22 carbon atoms); an aryl group (preferably of 6 to 30 carbon atoms); or a heteroaryl group (preferably of 2 to 30 carbon atoms). The alkyl group may be further substituted with an aryl group (preferably of 6 to 30 carbon atoms) or a heteroaryl group (preferably of 2 to 30 carbon atoms), and the aryl group or heteroaryl group may be further substituted with a linear, cyclic or branched alkyl group (preferably of 1 to 22 carbon atoms). Further, the alkyl group may be substituted with a halogen atom (for example, $-CF_3$). R is preferably a hydrogen atom, an alkyl group, an aryl group, or an alkyl-substituted aryl group.

<<Structural Unit C3>>

The structural unit C3 is a trivalent or higher structural unit. The structural unit C3 preferably includes an atom grouping that has the ability to transport an electric charge. From the viewpoint of improving the durability of the organic electronic element, the structural unit C3 is preferably no higher than hexavalent, and is more preferably trivalent or tetravalent. For example, from the viewpoint of improving the durability of the organic electronic element, the structural unit C3 may be selected from among substituted or unsubstituted monocyclic aromatic hydrocarbon structures and condensed polycyclic aromatic hydrocarbon structures, and structures containing one type, or two or more types, of these structures. In those cases where the structural unit C3 contains two or more of the above structures, the two or more structures may be the same or different.

Specific examples of the structural unit C3 are shown below. However, the structural unit C3 is not limited to the following structures.

[Chemical formula 56]

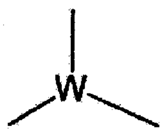
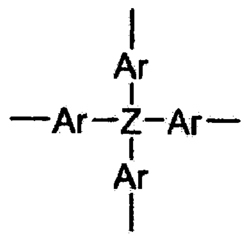
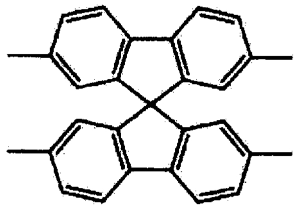
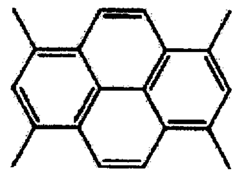

W represents a trivalent linking group, and for example, represents an arenetriyl group (preferably of 6 to 30 carbon atoms) or a heteroarenetriyl group (preferably of 2 to 30 carbon atoms). Each Ar independently represents a divalent linking group, and for example, may independently represent an arylene group or heteroarylene group of 2 to 30 carbon atoms. Ar preferably represents an arylene group, and more preferably a phenylene group. Z represents a carbon atom, a silicon atom or a phosphorus atom. In the structural units, the benzene rings and Ar groups may have a substituent, and examples of the substituent include the Rb groups in the structural unit C2.

An arenetriyl group is an atom grouping in which three hydrogen atoms have been removed from an aromatic hydrocarbon. A heteroarenetriyl is an atom grouping in which three hydrogen atoms have been removed from an aromatic heterocycle. The aromatic hydrocarbon and the aromatic heterocycle are as described above in relation to the aforementioned aryl group and heteroaryl group.

<<Structural Unit C1>>

The structural unit C1 is a monovalent structural unit. The structural unit C1 preferably includes an atom grouping that has the ability to transport an electric charge. For example, the structural unit C1 may be selected from among substituted or unsubstituted aromatic hydrocarbon structures and aromatic heterocyclic structures, and structures containing one type, or two or more types, of these structures. In those cases where the structural unit C1 contains two or more of the above structures, the two or more structures may be the same or different. In one embodiment, from the viewpoint of imparting durability without impairing the charge transport properties, the structural unit C1 is preferably a substituted or unsubstituted aromatic hydrocarbon structure, and is more preferably a substituted or unsubstituted benzene structure. Further, in another embodiment, when the charge transport polymer I has a polymerizable functional group at a terminal in the manner described below, the structural unit C1 may be a polymerizable structure (for example, a polymerizable functional group such as a pyrrolyl group).

For example, from the viewpoint of enabling functionality such as favorable solubility in solvents or good curability or the like to be imparted easily and effectively, the charge transport polymer I preferably has the structural unit C1 at the terminals.

Specific examples of the structural unit C1 are shown below. However, the structural unit C1 is not limited to the following structures.

[Chemical formula 57]

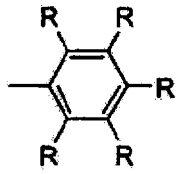

R is the same as R described in relation to the structural unit C2. In those cases where the charge transport polymer I has a polymerizable functional group described below at a terminal portion, it is preferable that at least one R group is a group containing a polymerizable functional group. Further, in those cases where the charge transport polymer I has an alkyl group at a terminal portion, it is preferable that at least one R group is an alkyl group.

(Proportions of Structural Units $AA^F$, $CZ^F$, and CZ and the like>>

The charge transport polymer I has structural units having "a nitrogen atom and an aromatic hydrocarbon group $Ar^F$ bonded to the nitrogen atom", such as the structural unit $AA^F$ and the structural unit $CZ^F$. From the viewpoint of obtaining satisfactory effects, the total proportion of these structural units, based on the total of all the structural units, is preferably at least 5 mol%, more preferably at least 10 mol%, and even more preferably 15 mol% or greater. The upper limit may be 100 mol%, but in those cases where the charge transport polymer I also has the structural unit CZ or the like, the upper limit is , for example, not more than 70 mol%, preferably not more than 50 mol%, and more preferably 20 mol% or less.

The charge transport polymer I has structural units containing a carbazole structure, such as the structural unit $CZ^F$ and the structural unit CZ. From the viewpoint of maintaining the $S_1$ level and the $T_1$ level, or from the viewpoint of improving the characteristics, the total proportion of all these structural units containing a carbazole structure is preferably at least 5 mol%, more preferably at least 10 mol%, and even more preferably 15 mol% or greater. From the viewpoint of improving the characteristics of the organic electronic element, the upper limit for this proportion, based on the total of all the structural units, is preferably not more than 50 mol%, more preferably not more than 30 mol%, and even more preferably 15 mol% or less.

In those cases where the charge transport polymer I includes the structural unit C, from the viewpoint of improving the characteristics of the organic electronic element, the proportion of the structural unit C, based on the total of all the structural units, is preferably not more than 50 mol%, more preferably not more than 30 mol%, and even more preferably 20 mol% or less. The lower limit is 0 mol%, but from the viewpoint of adjusting the HOMO level, or from the viewpoint of introducing substituents at the terminals, this proportion is, for example, at least 5 mol%, preferably at least 10 mol%, and even more preferably 15 mol% or greater.

If due consideration is given to obtaining the effects of the structural units having "a nitrogen atom and an aromatic hydrocarbon group $Ar^F$ bonded to the nitrogen atom" and the structural units containing a carbazole structure, the ratio (molar ratio) between the structural units having "a nitrogen atom and an aromatic hydrocarbon group $Ar^F$ bonded to the nitrogen atom", the structural units containing a carbazole structure, and the structural units C, listed in that order, preferably satisfies (5 to 100):(5 to 100):(90 to 0), more preferably (10 to 100):(10 to 100):(80 to 0), and even more preferably (20 to 100):(20 to 100):(60 to 0). In these ratios, the proportion of the structural unit $CZ^F$ is deemed to be included in both the proportion of the structural units having "a nitrogen atom and an aromatic hydrocarbon group $Ar^F$ bonded to the nitrogen atom" and the structural units containing a carbazole structure.

The proportion of each structural unit can be determined from the amount added of the monomer corresponding with that structural unit during synthesis of the charge transport polymer I. Further, the proportion of each structural unit can also be calculated as an average value using the integral of the spectrum attributable to the structural unit in the $^1H$-NMR (nuclear magnetic resonance) spectrum of the charge transport polymer I. In terms of simplicity, if the amounts added of the monomers are clear, then the proportion of the structural unit is preferably determined using these amounts. This applies to all subsequent determinations of structural unit proportions.

(Polymerizable Functional Group)

From the viewpoints of enabling the polymer to be cured by a polymerization reaction, thereby altering the degree of solubility in solvents, the charge transport polymer I may have at least one polymerizable functional group. A "polymerizable functional group" is a group which is able to form bonds upon the application of heat and/or light.

Examples of the polymerizable functional group include groups having a carbon-carbon multiple bond (such

as a vinyl group, allyl group, butenyl group, ethynyl group, acryloyl group, acryloyloxy group, acryloylamino group, methacryloyl group, methacryloyloxy group, methacryloylamino group, vinyloxy group and vinylamino group), groups having a small ring (including cyclic alkyl groups such as a cyclopropyl group and cyclobutyl group; cyclic ether groups such as an epoxy group (oxiranyl group) and oxetane group (oxetanyl group); diketene groups; episulfide groups; lactone groups; and lactam groups), and heterocyclic groups (such as a furanyl group, pyrrolyl group, thiophenyl group and silolyl group). Particularly preferred polymerizable functional groups include a vinyl group, acryloyl group, methacryloyl group, epoxy group and oxetane group, and from the viewpoint of improving the reactivity and the characteristics of the organic electronic element, a vinyl group, oxetane group or epoxy group is more preferred, an oxetane group or epoxy group is even more preferred, and an oxetane group is particularly desirable.

From the viewpoints of increasing the degree of freedom associated with the polymerizable functional group and facilitating the polymerization reaction, the main backbone of the charge transport polymer I and the polymerizable functional group are preferably linked via an alkylene chain. In the case where, for example, the organic layer is to be formed on an electrode, from the viewpoint of enhancing the affinity with hydrophilic electrodes of ITO or the like, the main backbone and the polymerizable functional group are preferably linked via a hydrophilic chain such as an ethylene glycol chain or a diethylene glycol chain. From the viewpoint of simplifying preparation of the monomer used for introducing the polymerizable functional group, the charge transport polymer I may have an ether linkage or an ester linkage at the terminal of the alkylene chain and/or the hydrophilic chain, namely, at the linkage site between these chains and the polymerizable functional group, and/or at the linkage site between these chains and the backbone of the charge transport polymer I. The aforementioned "group containing a polymerizable functional group" includes a polymerizable functional group itself, or a group containing a combination of a polymerizable functional group and an alkylene chain or the like.

The polymerizable functional group may be introduced at a terminal portion of the charge transport polymer I (namely, a monovalent structural unit), at a portion other than a terminal portion (namely, a divalent or trivalent or higher structural unit), or at both a terminal portion and a portion other than a terminal portion. From the viewpoint of the curability, the polymerizable functional group is preferably introduced at least at a terminal portion, and from the viewpoint of achieving a combination of favorable curability and charge transport properties, is preferably introduced only at terminal portions. Further, in those cases where the charge transport polymer I has a branched structure, the polymerizable functional group may be introduced within the main chain of the charge transport polymer I, introduced within a side chain, or introduced within both the main chain and a side chain.

From the viewpoint of contributing to a change in the degree of solubility, the polymerizable functional group is preferably included in the charge transport polymer I in a large amount. On the other hand, from the viewpoint of not impeding the charge transport properties, the amount included in the charge transport polymer I is preferably kept small. The amount of the polymerizable functional group may be set as appropriate with due consideration of these factors.

For example, from the viewpoint of obtaining a satisfactory change in the solubility, the number of polymerizable functional groups per one molecule of the charge transport polymer I is preferably at least 2, and more preferably 3 or greater. Further, from the viewpoint of maintaining good charge transport properties, the number of polymerizable functional groups is preferably not more than 1,000, and more preferably 500 or fewer.

The number of polymerizable functional groups per one molecule of the charge transport polymer I can be determined as an average value from the amount of the polymerizable functional group used in synthesizing the charge transport polymer (for example, the amount added of the monomer having the polymerizable functional group), the amounts added of the monomers corresponding with the various structural units, and the weight average molecular weight of the charge transport polymer I and the like. Further, the number of polymerizable functional groups can also be calculated as an average value using the ratio between the integral of the signal attributable to the polymerizable functional group and the integral of the total spectrum in the $^{1}$H-NMR (nuclear magnetic resonance) spectrum of the charge transport polymer I. In terms of simplicity, if the amounts added of the various components are clear, then the number of polymerizable functional groups is preferably determined from these amounts.

In those cases where the charge transport polymer I has a polymerizable functional group, from the viewpoint of efficiently curing the charge transport polymer I, the proportion of the polymerizable functional group, based on the total of all the structural units, is preferably at least 0.1 mol%, more preferably at least 1 mol%, and even more preferably 3 mol% or greater. Further, from the viewpoint of obtaining favorable charge transport properties, the proportion of the polymerizable functional group is preferably not more than 70 mol%, more preferably not more than 60 mol%, and even more preferably 50 mol% or less. Here, the "proportion of the polymerizable functional group" refers to the proportion of the structural unit having the polymerizable functional group.

(Structure of Charge Transport Polymer I)

Examples of partial structures contained in the charge transport polymer I are described below. However, the charge transport polymer I is not limited to polymers having the following partial structures.

<<Partial Structures of Linear Charge Transport Polymers I>>

[Chemical formula 58] T-L-L-L-L-*

<<Partial Structures of Branched Charge Transport Polymers I>>

[Chemical formula 59]

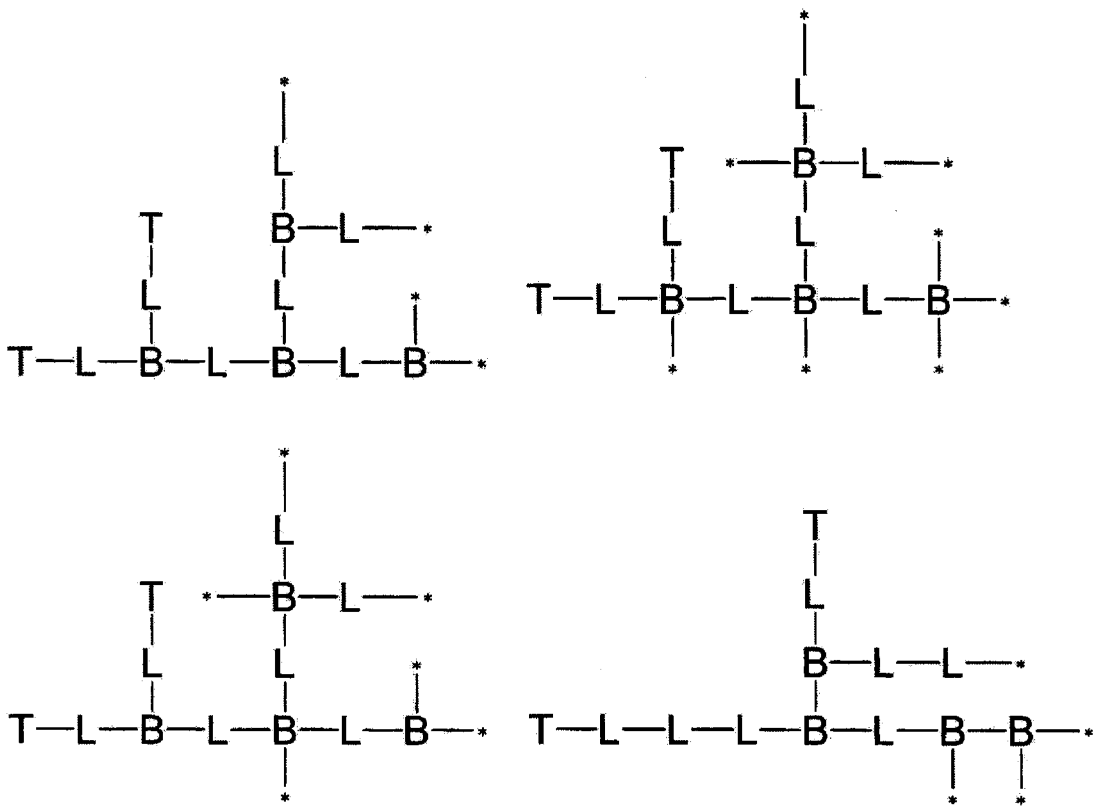

In the above partial structures, "L" represents a divalent structural unit, "B" represents a trivalent or tetravalent structural unit, and "T" represents a monovalent structural unit. The plurality of L units may be the same structural units or different structural units. This also applies for the B and T units.

Examples of "L" include a divalent "structural unit $AA^F$, structural unit $CZ^F$, structural unit CZ, structural unit AA and structural unit C (the structural unit C2)", examples of "B" include a trivalent or tetravalent "structural unit $AA^F$, structural unit $CZ^F$, structural unit CZ, structural unit AA and structural unit C (the structural unit C3)", and examples of "T" include a monovalent "structural unit $AA^F$, structural unit $CZ^F$, structural unit CZ, structural unit AA and structural unit C (the structural unit C1)". The partial structures include a structural unit having "a nitrogen atom and an aromatic hydrocarbon group $Ar^F$ bonded to the nitrogen atom" and a structural unit containing a carbazole structure as at least one of "L", "B" and "T". Alternatively, the partial structures include a structural unit which has "a nitrogen atom and an aromatic hydrocarbon group $Ar^F$ bonded to the nitrogen atom" and also contains a carbazole structure as at least one of "L", "B" and "T".

(Proportions of Structural Units L, B and T)

In those cases where the charge transport polymer I contains the structural unit L, from the viewpoint of obtaining

satisfactory charge transport properties, the proportion of the structural unit L, based on the total of all the structural units, is preferably at least 10 mol%, more preferably at least 20 mol%, and even more preferably 30 mol% or greater. Further, considering the structural unit T and the structural unit B that may be introduced as required, the proportion of the structural unit L is preferably not more than 95 mol%, more preferably not more than 90 mol%, and even more preferably 85 mol% or less.

From the viewpoint of enhancing the characteristics of the organic electronic element, or from the viewpoint of suppressing any increase in viscosity, enabling synthesis of the charge transport polymer I to be performed more favorably, the proportion of the structural unit T included in the charge transport polymer I, based on the total of all the structural units, is preferably at least 5 mol%, more preferably at least 10 mol%, and even more preferably 15 mol% or greater. Further, from the viewpoint of obtaining satisfactory charge transport properties, the proportion of the structural unit T is preferably not more than 60 mol%, more preferably not more than 55 mol%, and even more preferably 50 mol% or less.

In those cases where the charge transport polymer I contains the structural unit B, from the viewpoint of improving the durability of the organic electronic element, the proportion of the structural unit B, based on the total of all the structural units, is preferably at least 1 mol%, more preferably at least 5 mol%, and even more preferably 10 mol% or greater. Further, from the viewpoint of suppressing any increase in viscosity, enabling synthesis of the charge transport polymer I to be performed more favorably, or from the viewpoint of obtaining satisfactory charge transport properties, the proportion of the structural unit B is preferably not more than 50 mol%, more preferably not more than 40 mol%, and even more preferably 30 mol% or less.

Considering the balance between the charge transport properties, the durability, and the productivity and the like, the ratio (molar ratio) between the structural unit L and the structural unit T in a linear charge transport polymer I is preferably L:T = 100:(1 to 70), more preferably 100:(3 to 50), and even more preferably 100:(5 to 30). Further, in those cases where the charge transport polymer includes the structural unit B, the ratio (molar ratio) between the structural unit L, the structural unit T and the structural unit B is preferably L:T:B = 100:(10 to 200):(10 to 100), more preferably 100:(20 to 180):(20 to 90), and even more preferably 100:(40 to 160):(30 to 80).

(Number Average Molecular Weight, Weight Average Molecular Weight)

The number average molecular weight of the charge transport polymer I may be adjusted appropriately with due consideration of the solubility in solvents and the film formability and the like. From the viewpoint of ensuring superior charge transport properties, the number average molecular weight is preferably at least 500, more preferably at least 1,000, even more preferably at least 2,000, particularly preferably at least 3,000, and most preferably 5,000 or greater. Further, from the viewpoints of maintaining favorable solubility in solvents and facilitating the preparation of ink compositions, the number average molecular weight is preferably not more than 1,000,000, more preferably not more than 100,000, even more preferably not more than 50,000, particularly preferably not more than 10,000, and most preferably 7,000 or less.

The weight average molecular weight of the charge transport polymer I may be adjusted appropriately with due consideration of the solubility in solvents and the film formability and the like. From the viewpoint of ensuring superior charge transport properties, the weight average molecular weight is preferably at least 1,000, more preferably at least 3,000, even more preferably at least 5,000, and particularly preferably 7,000 or greater. Further, from the viewpoints of maintaining favorable solubility in solvents and facilitating the preparation of ink compositions, the weight average molecular weight is preferably not more than 1,000,000, more preferably not more than 500,000, even more preferably not more than 100,000, particularly preferably not more than 50,000, and most preferably 10,000 or less.

The number average molecular weight and the weight average molecular weight can be measured by gel permeation chromatography (GPC) using a calibration curve of standard polystyrenes.

From the viewpoint of stabilizing the film quality of the coating film, the number of structural units in the charge transport polymer I (the degree of polymerization) is preferably at least 2, more preferably at least 5, and even more preferably 10 or greater. Further, from the viewpoint of the solubility in solvents, the number of units is preferably not more than 1,000, more preferably not more than 700, and even more preferably 500 or fewer.

The number of structural units can be determined as an average value using the weight average molecular weight of the charge transport polymer I, the molecular weight of the various structural units, and the proportions of the various structural units.

(Specific Examples of the Charge Transport Polymer I)

Examples of the charge transport polymer I include polymers containing the structural units shown below. However, the charge transport polymer I is not limited to the following polymers.
[Chemical formula 60]

| | Structural Unit L | | Structural Unit T |
|---|---|---|---|
| 1 | 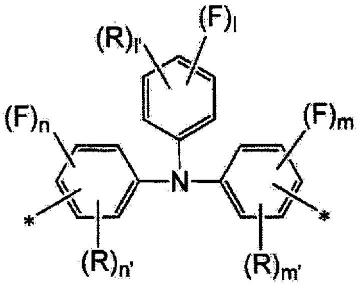 Structural Unit AA$^F$ 3 ~ 6 mol : | 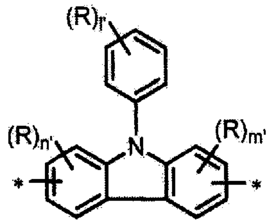 Structural Unit CZ 3 ~ 6 mol : | 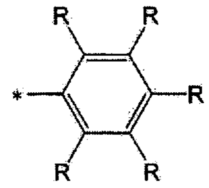 Structural Unit C 1 ~ 3 mol |
| 2 | 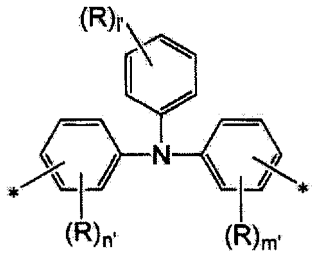 Structural Unit AA 3 ~ 6 mol : | 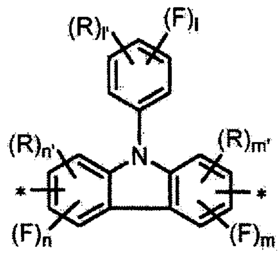 Structural Unit CZ$^F$ 3 ~ 6 mol : | 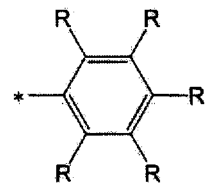 Structural Unit C 1 ~ 3 mol |

[Chemical formula 61]

| | Structural Unit B | Structural Unit L | Structural Unit T |
|---|---|---|---|
| 3 | 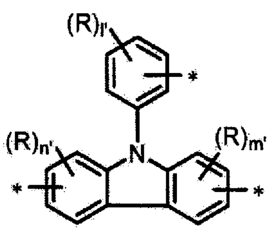 Structural Unit CZ 1 ~ 3 mol : | 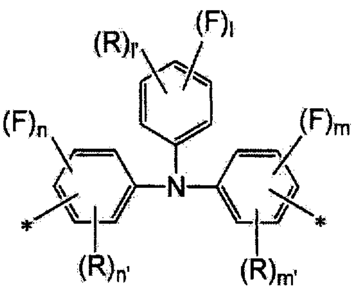 Structural Unit AA$^F$ 4 ~ 6 mol : | 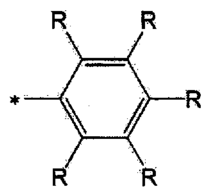 Structural Unit C 3 ~ 6 mol |
| 4 | 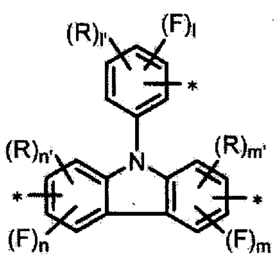 Structural Unit CZ$^F$ 1 ~ 3 mol : | 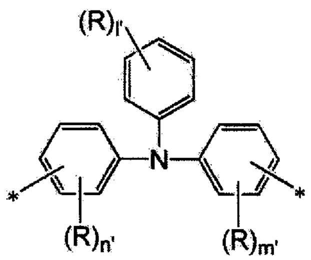 Structural Unit AA 4 ~ 6 mol : | 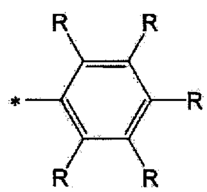 Structural Unit C 3 ~ 6 mol |

(continued)

| | Structural Unit B | Structural Unit L | Structural Unit T |
|---|---|---|---|
| 5 | 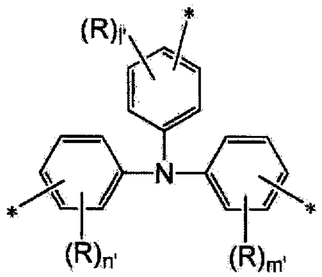 Structural Unit AA 1 ~ 3 mol : | 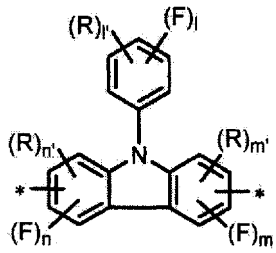 Structural Unit $CZ^F$ 4 ~ 6 mol : | 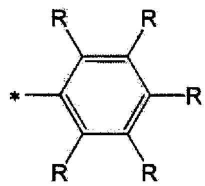 Structural Unit C 3 ~ 6 mol |
| 6 | 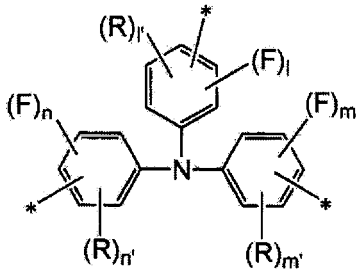 Structural Unit $AA^F$ 1 ~ 3 mol : | 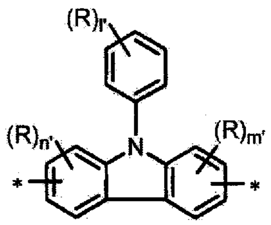 Structural Unit CZ 4 ~ 6 mol : | 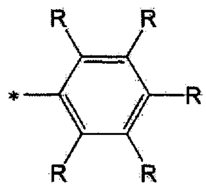 Structural Unit C 3 ~ 6mol |

(Production Method)

The charge transport polymer I can be produced by various synthesis methods, and there are no particular limitations. For example, the charge transport polymer I can be produced by a coupling reaction of the monomers used for forming the structural units that form the charge transport polymer I. The structural units are the basic units of the chemical structure of the polymer, and in one embodiment, refer to the monomer units derived from the monomers used in the polymer synthesis. Examples of coupling reactions that may be used include conventional reactions such as the Suzuki coupling, Negishi coupling, Sonogashira coupling, Stille coupling and Buchwald-Hartwig coupling reactions. The Suzuki coupling is a reaction in which a cross-coupling reaction is initiated between an aromatic boronic acid derivative and an aromatic halide using a Pd catalyst. By using a Suzuki coupling, the charge transport polymer I can be produced easily by bonding together the desired aromatic rings.

In the coupling reaction, a Pd(0) compound, Pd(II) compound, or Ni compound or the like is used as a catalyst. Further, a catalyst species generated by mixing a precursor such as tris(dibenzylideneacetone)dipalladium(0) or palladium(II) acetate with a phosphine ligand can also be used.

Examples of monomers that can be used in the Suzuki coupling reaction are shown below.

<<Monomer L>>

[Chemical formula 62] **$R^1$-L-$R^1$**

<<Monomer B>>

[Chemical formula 63]

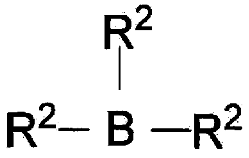

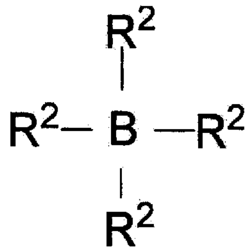

<<Monomer T>>

[Chemical formula 64] **$T\text{-}R^3$**

In the formulas, L represents a divalent structural unit, B represents a trivalent or tetravalent structural unit, and T represents a monovalent structural unit. $R^1$ to $R^3$ represent functional groups capable of forming bonds to one another, and each group preferably independently represents one type of group selected from the group consisting of a boronic acid group, a boronate ester group and a halogen group. Among the monomers used, at least one of "L", "B" and "T" may include a structural unit having "a nitrogen atom and an aromatic hydrocarbon group $Ar^F$ bonded to the nitrogen atom" and a structural unit containing a carbazole structure. Alternatively, at least one of "L", "B" and "T" may include a structural unit which has "a nitrogen atom and an aromatic hydrocarbon group $Ar^F$ bonded to the nitrogen atom" and also contains a carbazole structure.

These monomers can be obtained, for example, from Tokyo Chemical Industry Co., Ltd. and Sigma-Aldrich Japan K.K. and the like.

The charge transport polymer I may be a homopolymer of one type of monomer, or may be a copolymer of two or more types of monomer. In those cases where the charge transport polymer I is a copolymer, the copolymer may be an alternating, random, block or graft copolymer, or may be a copolymer having an intermediate type structure, such as a random copolymer having block-like properties.

The production method for the charge transport polymer I is not limited to the methods described above, and for example, the polymer may also be produced by preparing a charge transport polymer containing a carbazole structure, and then introducing a fluorine atom as a substituent onto the two benzene rings of the carbazole structure. Further, the polymer may also be produced by introducing the structural unit $AA^F$ and the structural unit CZ, or the structural unit $CZ^F$, into a charge transport polymer.

[Dopant]

The organic electronic material may also include a dopant. There are no particular limitations on the dopant, provided the dopant is a compound that yields a doping effect upon addition to the organic electronic material, enabling an improvement in the charge transport properties. Doping includes both p-type doping and n-type doping. In p-type doping, a substance that functions as an electron acceptor is used as the dopant, whereas in n-type doping, a substance that functions as an electron donor is used as the dopant. To improve the hole transport properties, p-type doping is preferably performed, whereas to improve the electron transport properties, n-type doping is preferably performed. The dopant used in the organic electronic material may be a dopant that exhibits either a p-type doping effect or an n-type doping effect. Further, a single type of dopant may be added alone, or a mixture of a plurality of types of dopant may be added.

The dopants used in p-type doping are electron-accepting compounds, and examples include Lewis acids, protonic acids, transition metal compounds, ionic compounds, halogen compounds and π-conjugated compounds. Specific examples include Lewis acids such as $FeCl_3$, $PF_5$, $AsF_5$, $SbF_5$, $BF_5$, $BCl_3$ and $BBr_3$; protonic acids, including inorganic acids such as HF, HCl, HBr, $HNO_5$, $H_2SO_4$ and $HClO_4$, and organic acids such as benzenesulfonic acid, p-toluenesulfonic acid, dodecylbenzenesulfonic acid, polyvinylsulfonic acid, methanesulfonic acid, trifluoromethanesulfonic acid, trifluoroacetic acid, 1-butanesulfonic acid, vinylphenylsulfonic acid and camphorsulfonic acid; transition metal compounds such as FeOCl, $TiCl_4$, $ZrCl_4$, $HfC1_4$, $NbF_5$, $AlCl_3$, $NbCl_5$, $TaCl_5$ and $MoF_5$; ionic compounds, including salts containing a perfluoro anion such as a tetrakis(pentafluorophenyl)borate ion, tris(trifluoromethanesulfonyl)methide ion, bis(trifluoromethanesulfonyl)imide ion, hexafluoroantimonate ion, $AsF_6^-$ (hexafluoroarsenate ion), $BF_4^-$ (tetrafluoroborate

ion) or $PF_6^-$ (hexafluorophosphate ion), and salts having a conjugate base of an aforementioned protonic acid as an anion; halogen compounds such as $Cl_2$, $Br_2$, $I_2$, ICl, $ICl_3$, IBr and IF; and $\pi$-conjugated compounds such as TCNE (tetracyanoethylene) and TCNQ (tetracyanoquinodimethane). Further, the electron-accepting compounds disclosed in JP 2000-36390 A, JP 2005-75948 A, and JP 2003-213002 A and the like can also be used. Lewis acids, ionic compounds, and $\pi$-conjugated compounds and the like are preferred, and ionic compounds are more preferred. Among such compounds, onium salts can be used particularly favorably.

Onium salts are compounds that include an onium ion. Examples of onium salts include salts containing onium ions such as ammonium, phosphonium, oxonium, sulfonium and iodonium ions.

The dopants used in n-type doping are electron-donating compounds, and examples include alkali metals such as Li and Cs; alkaline earth metals such as Mg and Ca; salts of alkali metals and/or alkaline earth metals such as LiF and $Cs_2CO_3$; metal complexes; and electron-donating organic compounds.

In those cases where the charge transport polymer I has a polymerizable functional group, in order to facilitate a change in the degree of solubility of the organic layer, the use of a compound that can function as a polymerization initiator for the polymerizable functional group as the dopant is preferred.

[Other Optional Components]

The organic electronic material may also contain other charge transport polymers, and charge transport low-molecular weight compounds and the like.

[Contents]

From the viewpoint of obtaining favorable charge transport properties, the amount of the charge transport polymer I, relative to the total mass of the organic electronic material, is preferably at least 50% by mass, more preferably at least 70% by mass, and even more preferably 80% by mass or greater. The amount may be 100% by mass.

When a dopant is included, from the viewpoint of improving the charge transport properties of the organic electronic material, the amount of the dopant, relative to the total mass of the organic electronic material, is preferably at least 0.01% by mass, more preferably at least 0.1% by mass, and even more preferably 0.5% by mass or greater. Further, from the viewpoint of maintaining favorable film formability, the amount of the dopant, relative to the total mass of the organic electronic material, is preferably not more than 50% by mass, more preferably not more than 30% by mass, and even more preferably 20% by mass or less.

<Ink Composition>

According to one embodiment, an ink composition contains the organic electronic material described above and a solvent capable of dissolving or dispersing the material. By using this ink composition, an organic layer can be formed easily using a simple coating method.

[Solvent]

Water, organic solvents, or mixed solvents thereof can be used as the solvent. Examples of the organic solvent include alcohols such as methanol, ethanol and isopropyl alcohol; alkanes such as pentane, hexane and octane; cyclic alkanes such as cyclohexane; aromatic hydrocarbons such as benzene, toluene, xylene, mesitylene, tetralin and diphenylmethane; aliphatic ethers such as ethylene glycol dimethyl ether, ethylene glycol diethyl ether and propylene glycol-1-monomethyl ether acetate; aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole and 2,4-dimethylanisole; aliphatic esters such as ethyl acetate, n-butyl acetate, ethyl lactate and n-butyl lactate; aromatic esters such as phenyl acetate, phenyl propionate, methyl benzoate, ethyl benzoate, propyl benzoate and n-butyl benzoate; amide-based solvents such as N,N-dimethylformamide and N,N-dimethylacetamide; as well as dimethyl sulfoxide, tetrahydrofuran, acetone, chloroform and methylene chloride. Preferred solvents include aromatic hydrocarbons, aliphatic esters, aromatic esters, aliphatic ethers, and aromatic ethers and the like.

[Polymerization Initiator]

In those cases where the charge transport polymer I has a polymerizable functional group, the ink composition preferably contains a polymerization initiator. Conventional radical polymerization initiators, cationic polymerization initiators, and anionic polymerization initiators and the like can be used as the polymerization initiator. From the viewpoint of enabling simple preparation of the ink composition, the use of a substance that exhibits both a function as a dopant

and a function as a polymerization initiator is preferred. Examples of such substances include the ionic compounds described above.

[Additives]

The ink composition may also contain additives as optional components. Examples of these additives include polymerization inhibitors, stabilizers, thickeners, gelling agents, flame retardants, antioxidants, reduction inhibitors, oxidizing agents, reducing agents, surface modifiers, emulsifiers, antifoaming agents, dispersants and surfactants.

[Contents]

The amount of the solvent in the ink composition can be determined with due consideration of the use of the composition in various coating methods. For example, the amount of the solvent is preferably an amount that yields a ratio of the charge transport polymer I relative to the solvent that is at least 0.1% by mass, more preferably at least 0.2% by mass, and even more preferably 0.5% by mass or greater. Further, the amount of the solvent is preferably an amount that yields a ratio of the charge transport polymer I relative to the solvent that is not more than 20% by mass, more preferably not more than 15% by mass, and even more preferably 10% by mass or less.

<Organic Layer>

According to one embodiment, an organic layer is a layer containing the organic electronic material described above. The organic electronic material is contained in the organic layer as the organic electronic material itself, or as a derivative derived from the organic electronic material such as a polymerization product, a reaction product or a decomposition product. The organic layer is preferably a layer formed using the organic electronic material or the ink composition described above.

Further, according to one embodiment, a method for producing the organic layer includes a step of applying the ink composition. The production method may also include other optional steps such as a drying step or a step of curing the charge transport polymer I. By using the ink composition, the organic layer can be formed favorably using a coating method.

Examples of the coating method include conventional methods such as spin coating methods; casting methods; dipping methods; plate-based printing methods such as relief printing, intaglio printing, offset printing, lithographic printing, relief reversal offset printing, screen printing and gravure printing; and plateless printing methods such as inkjet methods. When the organic layer is formed by a coating method, the organic layer (coating layer) obtained following coating may be dried on a hot plate or in an oven to remove the solvent.

In those cases where the charge transport polymer I has a polymerizable functional group, the charge transport polymer I can be subjected to a polymerization reaction by performing light irradiation or a heat treatment or the like, thereby changing the degree of solubility of the organic layer. By stacking organic layers having changed degrees of solubility, multilayering of an organic electronic element can be performed with ease.

From the viewpoint of improving the efficiency of charge transport, the thickness of the organic layer obtained following drying or curing is preferably at least 0.1 nm, more preferably at least 1 nm, and even more preferably 3 nm or greater. Further, from the viewpoint of reducing the electrical resistance, the thickness of the organic layer is preferably not more than 300 nm, more preferably not more than 200 nm, and even more preferably 100 nm or less.

<Organic Electronic Element>

According to one embodiment, an organic electronic element has at least the organic layer described above. Examples of the organic electronic element include an organic EL element, an organic photoelectric conversion element, and an organic transistor. The organic electronic element preferably has a structure in which at least an organic layer is disposed between a pair of electrodes. Further, a method for producing the organic electronic element includes at least a step of applying the ink composition described above to form an organic layer.

[Organic EL Element]

According to one embodiment, an organic EL element has at least the organic layer described above. The organic EL element typically includes a light-emitting layer, an anode, a cathode and a substrate, and if necessary, may also have other functional layers such as a hole injection layer, electron injection layer, hole transport layer or electron transport layer. Each layer may be formed by a vapor deposition method, or by a coating method. The organic EL element preferably has the organic layer as the light-emitting layer or as another functional layer, more preferably has the organic

layer as a functional layer, and even more preferably has the organic layer as at least one of a hole injection layer and a hole transport layer. Further, a method for producing the organic electronic element includes at least a step of applying the ink composition described above to form an organic layer.

One example of a preferred embodiment of the organic EL element is an element having at least the organic layer described above and a light-emitting layer that contacts the organic layer, and is preferably an element having at least an anode, a hole injection layer, a hole transport layer, a light-emitting layer and a cathode, wherein the hole transport layer is the organic layer described above. Although there are no particular limitations on the light-emitting layer, from the viewpoint of achieving the effects of the organic layer, a light-emitting layer that emits light in the blue to green region (for example, a green peak wavelength of 495 to 570 nm) upon voltage application is preferred. In the latter embodiment, the hole injection layer may be an aforementioned organic layer or another organic layer, and in one example, from the viewpoint of improving the characteristics of the organic EL element, is preferably another organic layer.

FIG. 1 is a cross-sectional schematic view illustrating one embodiment of a structure contained in an organic EL element. The structure of FIG 1 has an organic layer 11 of one embodiment, and a light-emitting layer 12 that contacts the organic layer. FIG. 2 is a cross-sectional schematic view illustrating one embodiment of the organic EL element. The organic EL element in FIG. 2 is an element with a multilayer structure, and has a substrate 8, an anode 2, a hole injection layer 3, a hole transport layer 6 formed from an organic layer of one embodiment, a light-emitting layer 1, an electron transport layer 7, an electron injection layer 5 and a cathode 4 provided in that order.

Each of the layers that may be included in the organic EL element is described below.

[Light-Emitting Layer]

Examples of materials that can be used for the light-emitting layer include light-emitting materials such as low-molecular weight compounds, polymers, and dendrimers and the like. Polymers exhibit good solubility in solvents, meaning they are suitable for coating methods, and are consequently preferred. Examples of the light-emitting material include fluorescent materials, phosphorescent materials, and thermally activated delayed fluorescent materials (TADF).

Specific examples of the fluorescent materials include low-molecular weight compounds such as perylene, coumarin, rubrene, quinacridone, stilbene, color laser dyes, aluminum complexes, and derivatives of these compounds; polymers such as polyfluorene, polyphenylene, polyphenylenevinylene, polyvinylcarbazole, fluorene-benzothiadiazole copolymers, fluorene-triphenylamine copolymers, and derivatives of these polymers; and mixtures of the above materials.

Examples of materials that can be used as the phosphorescent materials include metal complexes and the like containing a metal such as Ir or Pt. Specific examples of Ir complexes include FIr(pic) (iridium(III) bis[(4,6-difluorophenyl)-pyridinato-N,$C^2$] picolinate) which emits blue light, $Ir(ppy)_3$ (fac-tris(2-phenylpyridine)iridium) which emits green light, and $(btp)_2Ir(acac)$ (bis[2-(2'-benzo[4,5-a]thienyl)pyridinato-N,$C^3$]iridium(acetyl-acetonate)) and $Ir(piq)_3$ (tris(1-phenylisoquinoline)iridium) which emit red light. Specific examples of Pt complexes include PtOEP (2,3,7,8,12,13,17,18-octaethyl-21H,23H-porphyrin-platinum) which emits red light.

When the light-emitting layer contains a phosphorescent material, a host material is preferably also included in addition to the phosphorescent material. Low-molecular weight compounds, polymers, and dendrimers can be used as this host material. Examples of the low-molecular weight compounds include CBP (4,4'-bis(9H-carbazol-9-yl)-biphenyl), mCP (1,3-bis(9-carbazolyl)benzene), CDBP (4,4'-bis(carbazol-9-yl)-2,2'-dimethylbiphenyl), and derivatives of these compounds. Examples of the polymers include the organic electronic material described above, polyvinylcarbazole, polyphenylene, polyfluorene, and derivatives of these polymers.

Examples of the thermally activated delayed fluorescent materials include the compounds disclosed in Adv. Mater., 21, 4802-4906 (2009); Appl. Phys. Lett., 98, 083302 (2011); Chem. Comm., 48, 9580 (2012); Appl. Phys. Lett., 101, 093306 (2012); J. Am. Chem. Soc., 134, 14706 (2012); Chem. Comm., 48, 11392 (2012); Nature, 492, 234 (2012); Adv. Mater., 25, 3319 (2013); J. Phys. Chem. A, 117, 5607 (2013); Phys. Chem. Chem. Phys., 15, 15850 (2013); Chem. Comm., 49, 10385 (2013); and Chem. Lett., 43, 319 (2014) and the like.

[Hole Transport Layer, Hole Injection Layer]

Examples of materials that may be used for the hole transport layer and the hole injection layer include the organic electronic material described above. Further, other examples of materials that may be used for the hole transport layer and the hole injection layer include polymers that differ from the charge transport polymer I (hereafter, this type of different charge transport polymer is also referred to as a "charge transport polymer II"). With the exceptions of not having a nitrogen atom and a fluorine-substituted aromatic hydrocarbon group $Ar^F$ bonded to the nitrogen atom, and/or not having a structural unit containing a carbazole structure, the charge transport polymer II may have a similar structure to the charge transport polymer I. In other words, the charge transport polymer II may have, for example, the structural unit $AA^F$, the structural unit AA and/or the structural unit C. Furthermore, the charge transport polymer II may have, for example, the structural unit CZ, the structural unit AA and/or the structural unit C.

Moreover, examples of conventional materials that may be used include aromatic amine-based compounds (for example, aromatic diamines such as N,N'-di(naphthalen-1-yl)-N,N'-diphenyl-benzidine (a-NPD)), phthalocyanine-based compounds, and thiophene-based compounds (for example, thiophene-based conductive polymers such as poly(3,4-ethylenedioxythiophene):poly(4-styrenesulfonate) (PEDOT:PSS) and the like).

[Electron Transport Layer, Electron Injection Layer]

Examples of materials that may be used for the electron transport layer and the electron injection layer include phenanthroline derivatives, bipyridine derivatives, nitro-substituted fluorene derivatives, diphenylquinone derivatives, thiopyran dioxide derivatives, condensed-ring tetracarboxylic acid anhydrides of naphthalene and perylene and the like, carbodiimides, fluorenylidenemethane derivatives, anthraquinodimethane and anthrone derivatives, oxadiazole derivatives, thiadiazole derivatives, benzimidazole derivatives, quinoxaline derivatives, and aluminum complexes. Further, the organic electronic material described above may also be used.

[Cathode]

Examples of the cathode material include metals or metal alloys, such as Li, Ca, Mg, Al, In, Cs, Ba, Mg/Ag, LiF and CsF.

[Anode]

Examples of the anode material include metals (for example, Au) or other materials having conductivity. Examples of the other materials include oxides (for example, ITO: indium oxide/tin oxide), and conductive polymers (for example, polythiophene-polystyrene sulfonate mixtures (PEDOT:PSS)).

[Substrate]

Glass and plastics and the like can be used as the substrate. The substrate is preferably transparent, and preferably has flexibility. Quartz glass and light-transmitting resin films and the like can be used particularly favorably.

Examples of the resin films include films containing polyethylene terephthalate, polyethylene naphthalate, polyethersulfone, polyetherimide, polyetheretherketone, polyphenylene sulfide, polyarylate, polyimide, polycarbonate, cellulose triacetate or cellulose acetate propionate.

In those cases where a resin film is used, an inorganic substance such as silicon oxide or silicon nitride may be coated onto the resin film to inhibit the transmission of water vapor and oxygen and the like.

[Emission Color]

There are no particular limitations on the color of the light emission from the organic EL element. White organic EL elements can be used for various illumination fixtures, including domestic lighting, in-vehicle lighting, watches and liquid crystal backlights, and are consequently preferred.

The method used for forming a white organic EL element involves using a plurality of light-emitting materials to emit a plurality of colors simultaneously, and then mixing the emitted colors to obtain a white light emission. There are no particular limitations on the combination of the plurality of emission colors, and examples include combinations that include three maximum emission wavelengths for blue, green and red, and combinations that include two maximum emission wavelengths such as blue and yellow, or yellowish green and orange. Control of the emission color can be achieved by appropriate adjustment of the types and amounts of the light-emitting materials.

<Display Element, Illumination Device, Display Device>

According to one embodiment, a display element includes the organic EL element described above. For example, by using the organic EL element as the element corresponding with each color pixel of red, green and blue (RGB), a color display element can be obtained. Examples of the image formation method include a simple matrix in which organic EL elements arrayed in a panel are driven directly by an electrode arranged in a matrix, and an active matrix in which a thin-film transistor is positioned on, and drives, each element.

Further, according to one embodiment, an illumination device includes the organic EL element described above. Moreover, according to one embodiment, a display device includes the illumination device and a liquid crystal element as a display unit. For example, the display device may be a device that uses the illumination device as a backlight, and uses a conventional liquid crystal element as the display unit, namely a liquid crystal display device.

Examples

The embodiments of the present invention are described below in further detail using a series of examples. However, the embodiments of the present invention are not limited by the following examples.

<Example I>

[Production of Charge Transport Polymers]

<Preparation of Pd Catalyst>

In a glove box under a nitrogen atmosphere at room temperature, tris(dibenzylideneacetone)dipalladium (73.2 mg, 80 μmol) was weighed into a sample tube, anisole (15 mL) was added, and the resulting mixture was agitated for 30 minutes. In a similar manner, tri-tert-butylphosphine (129.6 mg, 640 μmol) was weighed into a sample tube, anisole (5 mL) was added, and the resulting mixture was agitated for 5 minutes. The two solutions were then mixed together and stirred for 30 minutes at room temperature to obtain a Pd catalyst solution. All the solvents used in the catalyst preparation were deaerated by nitrogen bubbling for at least 30 minutes prior to use.

(Charge Transport Polymer c1)

A three-neck round-bottom flask was charged with a monomer 1 shown below (4.0 mmol), a monomer 2 shown below (5.0 mmol), a monomer 3 shown below (2.0 mmol) and anisole (20 mL), and the Pd catalyst solution (7.5 mL) was then added and stirred. After stirring for 30 minutes, a 10% aqueous solution of tetraethylammonium hydroxide (20 mL) was added to the flask. The resulting mixture was heated under reflux for 2 hours. All the operations up to this point were conducted under a stream of nitrogen. Further, all of the solvents were deaerated by nitrogen bubbling for at least 30 minutes prior to use.

[Chemical formula 65]

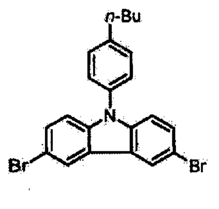
Monomer 1

+

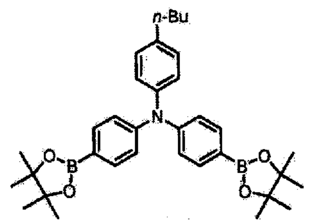
Monomer 2

+

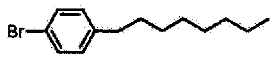
Monomer 3

After completion of the reaction, the organic layer was washed with water, and the organic layer was then poured into methanol-water (9:1). The precipitate that was produced was collected by filtration under reduced pressure, and washed with methanol-water (9:1). The thus obtained precipitate was dissolved in toluene, and re-precipitated from methanol. The resulting precipitate was collected by filtration under reduced pressure and dissolved in toluene, and a metal adsorbent ("Triphenylphosphine, polymer-bound on styrene-divinylbenzene copolymer", manufactured by Strem Chemicals Inc., 200 mg per 100 mg of the precipitate) was added to the solution and stirred overnight. Following completion of the stirring, the metal adsorbent and other insoluble matter were removed by filtration, and the filtrate was concentrated using a rotary evaporator. The concentrate was dissolved in toluene, and then re-precipitated from methanol-acetone (8:3). The thus produced precipitate was collected by filtration under reduced pressure and washed with methanol-acetone (8:3). The thus obtained precipitate was then dried under vacuum to obtain a charge transport polymer c1. The number average molecular weight was 5,600 and the weight average molecular weight was 9,000.

(Charge Transport Polymer e1)

With the exception of using the monomer 1 shown below (4.0 mmol), a monomer 4 shown below (5.0 mmol) and the monomer 3 shown below (2.0 mmol), the same procedure as that described for the production of the charge transport polymer c1 was used to obtain a charge transport polymer e1 (number average molecular weight: 5,000, weight

average molecular weight: 8,000).

[Chemical formula 66]

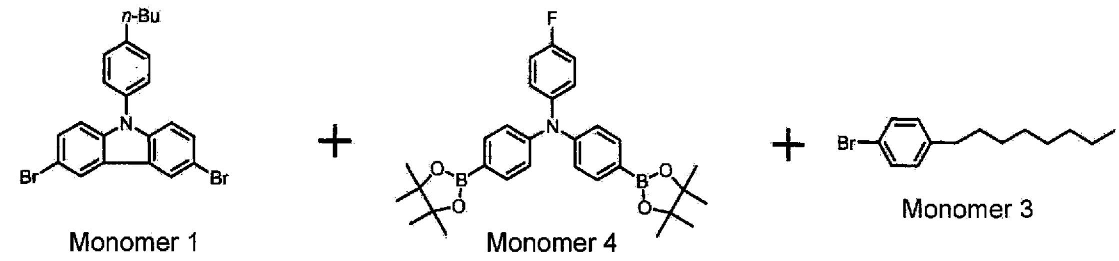

Monomer 1 + Monomer 4 + Monomer 3

(Charge Transport Polymer e2)

With the exception of using the monomer 1 shown below (4.0 mmol), a monomer 5 shown below (5.0 mmol) and the monomer 3 shown below (2.0 mmol), the same procedure as that described for the production of the charge transport polymer c1 was used to obtain a charge transport polymer e2 (number average molecular weight: 5,700, weight average molecular weight: 8,700).

[Chemical formula 67]

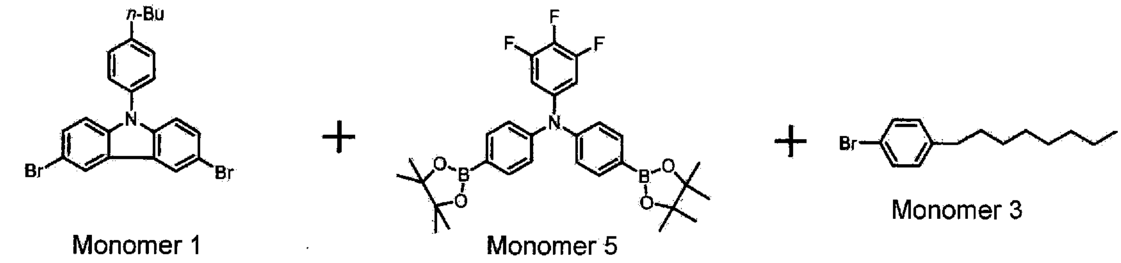

Monomer 1 + Monomer 5 + Monomer 3

(Number Average Molecular Weight and Weight Average Molecular Weight)

The measurement conditions for the number average molecular weight and the weight average molecular weight were as follows.

Apparatus:

High-performance liquid chromatograph "Prominence", manufactured by Shimadzu Corporation
Feed pump (LC-20AD)
Degassing unit (DGU-20A)
Autosampler (SIL-20AHT)
Column oven (CTO-20A)
PDA detector (SPD-M20A)
Refractive index detector (RID-20A)

Columns:

Gelpack (a registered trademark)
GL-A160S (product number: 686-1J27)
GL-A150S (product number: 685-1J27)
manufactured by Hitachi Chemical Co., Ltd.

Eluent: Tetrahydrofuran (THF) (for HPLC, contains stabilizers), manufactured by Wako Pure Chemical Industries, Ltd.
Flow rate: 1 mL/min

Column temperature: 40°C
Detection wavelength: 254 nm
Molecular weight standards: PStQuick A/B/C, manufactured by Tosoh Corporation

[Evaluations of Charge Transport Polymers]

For each charge transport polymer, the methods described below were used to measure the HOMO energy level, the energy gap between the $S_0$ level and the $S_1$ level, and the energy gap between the $S_0$ level and the $T_1$ level. The evaluation results are shown in Table 1.

(HOMO Energy Level)

A toluene solution of the charge transport polymer (concentration: 1.0% by mass) was filtered through a polytetrafluoroethylene filter (13JP020AN, pore size: 0.2 μm, manufactured by the Advantec Group) under normal atmospheric conditions. Further, a quartz glass substrate (22 mm × 29 mm × 0.7 mm) was irradiated with ultraviolet light for 10 minutes using a desktop light surface processing unit (SSP16-110, manufactured by Sen Lights Corporation, light source: PL16-110A), thereby removing organic matter from the quartz glass substrate. A few drops of the toluene solution of the charge transport polymer were then dripped onto the quartz glass substrate, spin coating was performed under conditions including 3,000 $min^{-1}$ for 60 seconds, and the quartz glass substrate was then baked at 120°C for 10 minutes to form an organic thin film with a thickness of 50 nm. The ionization potential of the organic thin film was then measured using a photoelectron spectrometer (AC-5, manufactured by Riken Keiki Co., Ltd.). The thus obtained value was deemed the HOMO energy level.

($S_1$ Energy)

For an organic thin film obtained using the same method as that described above, the absorption in the wavelength range from 200 to 600 nm was measured using a spectrophotometer (U-3900H, manufactured by Hitachi High-Tech Science Corporation). The $S_1$ energy was determined from the absorption edge wavelength on the long wavelength side of the obtained UV-Vis absorption spectrum.

($T_1$ Energy)

A 2-methyltetrahydrofuran solution of the charge transport polymer (concentration: $1.0 \times 10^{-4}$% by mass) was deoxygenated in a glass measurement tube by performing nitrogen bubbling, and the sample was then gradually immersed in liquid nitrogen and frozen. Using a fluorescence spectrophotometer (F-7000, manufactured by Hitachi High-Tech Science Corporation) and the attached phosphorescence measuring unit, the phosphorescence of the frozen solution was measured in the wavelength range from 400 to 700 nm, and the $T_1$ energy was determined from the peak wavelength at the short wavelength side.

[Table 1]

Table 1

| Charge transport polymer | HOMO level (absolute value) [eV] | ΔE (S0-S1) [eV] | ΔE (S0-T1) [eV] |
|---|---|---|---|
| c1 | 5.22 | 3.00 | 2.42 |
| e1 | 5.50 | 3.10 | 2.48 |
| e2 | 5.60 | 3.12 | 2.45 |

Compared with the charge transport polymer cl, the charge transport polymers e1 and e2 had deeper HOMO levels, and the $S_1$ energy and $T_1$ energy were larger.

<Example II>

[Production of Charge Transport Polymers]

(Charge Transport Polymer C1)

With the exception of altering the monomers to a monomer 6 shown below (2.0 mmol), the monomer 2 shown below (5.0 mmol), the monomer 3 shown below (3.0 mmol) and a monomer 7 shown below (1.0 mmol), the same procedure as that described for Example I was used to obtain a charge transport polymer C1 (number average molecular weight: 5,700, weight average molecular weight: 8,600).

[Chemical formula 68]

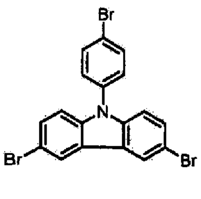

Monomer 6

+

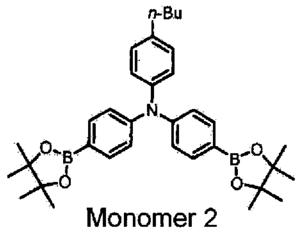

Monomer 2

+

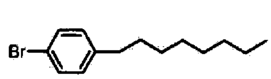

Monomer 3

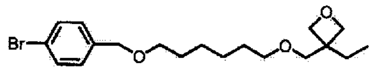

Monomer 7

(Charge Transport Polymer E1)

With the exception of using the monomer 6 shown below (2.0 mmol), the monomer 4 shown below (5.0 mmol), the monomer 3 shown below (3.0 mmol) and the monomer 7 shown below (1.0 mmol), the same procedure as that described for Example I was used to obtain a charge transport polymer E1 (number average molecular weight: 5,300, weight average molecular weight: 8,400).

[Chemical formula 69]

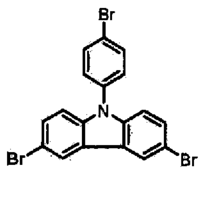

Monomer 6

+

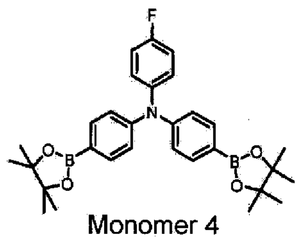

Monomer 4

+

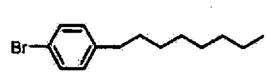

Monomer 3

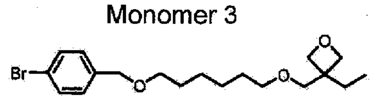

Monomer 7

(Charge Transport Polymer E2)

With the exception of using the monomer 6 shown below (2.0 mmol), the monomer 5 shown below (5.0 mmol), the monomer 3 shown below (3.0 mmol) and the monomer 7 shown below (1.0 mmol), the same procedure as that described for Example I was used to obtain a charge transport polymer E2 (number average molecular weight: 5,100, weight average molecular weight: 8,500).

[Chemical formula 70]

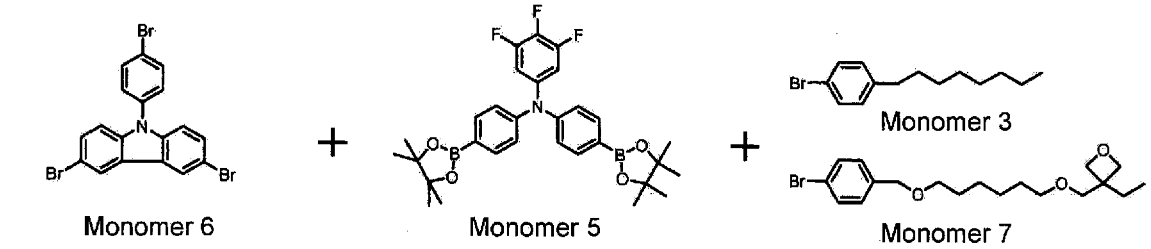

Monomer 6 + Monomer 5 + Monomer 3 Monomer 7

(Charge Transport Polymer E3)

With the exception of using the monomer 6 shown below (2.0 mmol), a monomer 8 shown below (5.0 mmol), the monomer 3 shown below (3.0 mmol) and the monomer 7 shown below (1.0 mmol), the same procedure as that described for Example I was used to obtain a charge transport polymer E3 (number average molecular weight: 5,500, weight average molecular weight: 8,500).

[Chemical formula 71]

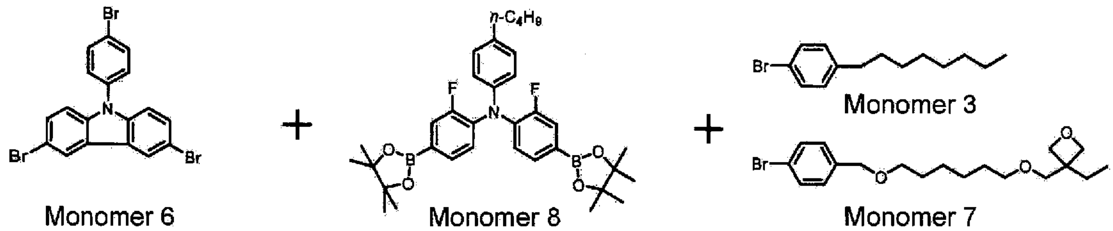

Monomer 6 + Monomer 8 + Monomer 3 Monomer 7

(Charge Transport Polymer E4)

With the exception of using the monomer 6 shown below (2.0 mmol), a monomer 9 shown below (5.0 mmol), the monomer 3 shown below (3.0 mmol) and the monomer 7 shown below (1.0 mmol), the same procedure as that described for Example I was used to obtain a charge transport polymer E4 (number average molecular weight: 6,000, weight average molecular weight: 9,500).

[Chemical formula 72]

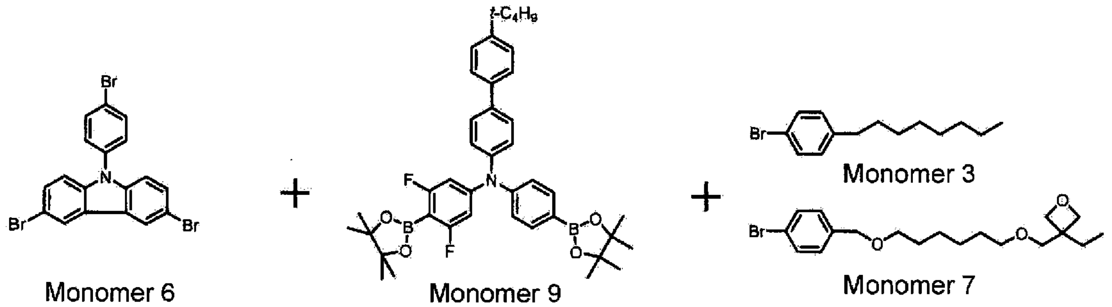

Monomer 6 + Monomer 9 + Monomer 3 Monomer 7

(Charge Transport Polymer E5)

With the exception of using a monomer 10 shown below (2.0 mmol), the monomer 2 shown below (5.0 mmol), the monomer 3 shown below (3.0 mmol) and the monomer 7 shown below (1.0 mmol), the same procedure as that described for Example I was used to obtain a charge transport polymer E5 (number average molecular weight: 5,800,

weight average molecular weight: 8,900).

[Chemical formula 73]

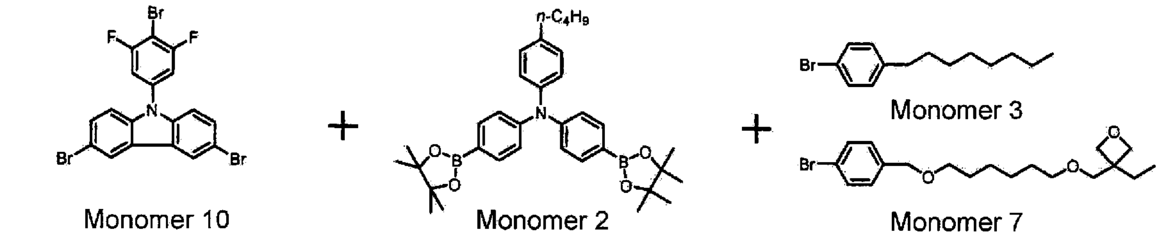

Monomer 10 + Monomer 2 + Monomer 3, Monomer 7

(Charge Transport Polymer C2)

With the exception of using a monomer 11 shown below (2.0 mmol), the monomer 2 shown below (5.0 mmol), the monomer 3 shown below (3.0 mmol) and the monomer 7 shown below (1.0 mmol), the same procedure as that described for Example I was used to obtain a charge transport polymer C2 (number average molecular weight: 5,900, weight average molecular weight: 9,900).

[Chemical formula 74]

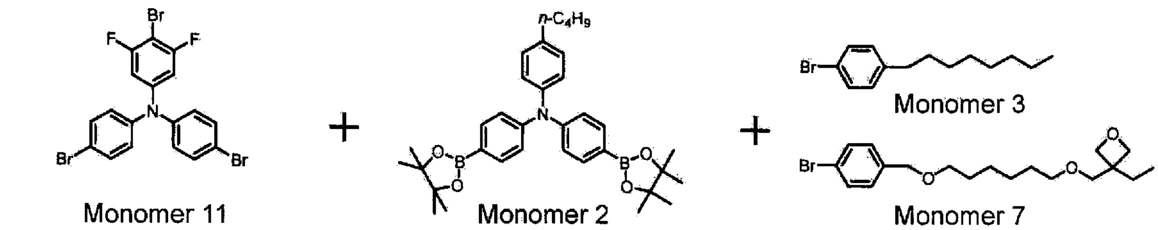

Monomer 11 + Monomer 2 + Monomer 3, Monomer 7

[Evaluations of Charge Transport Polymers]

Using the same methods as Example I, the HOMO energy level, the energy gap between the $S_0$ level and the $S_1$ level, and the energy gap between the $S_0$ level and the $T_1$ level were measured for each of the charge transport polymers. The evaluation results are shown in Table 2.

[Table 2]

Table 2

| Charge transport polymer | HOMO level (absolute value) [eV] | ΔE (S0-S1) [eV] | ΔE (S0-T1) [eV] |
|---|---|---|---|
| C1 | 5.23 | 3.00 | 2.42 |
| E1 | 5.51 | 3.07 | 2.48 |
| E2 | 5.62 | 3.14 | 2.43 |
| E3 | 5.60 | 3.10 | 2.46 |
| E4 | 5.55 | 3.10 | 2.49 |
| E5 | 5.28 | 3.06 | 2.49 |
| C2 | 5.30 | 2.98 | 2.36 |

Compared with the charge transport polymer C1, the charge transport polymers E1 to E5 had deeper HOMO levels, and the $S_1$ energy and $T_1$ energy values were larger. Further, compared with the charge transport polymer C2,

the $S_1$ energy and $T_1$ energy values were larger. In the charge transport polymer E2 in which the number of fluorine atoms was 3, the HOMO level was the deepest, and the $S_1$ energy was also the largest.

<Production of Organic EL Elements>

(Polymer for Hole Injection Layer)

With the exception of using a monomer 12 shown below (2.0 mmol), the monomer 2 shown below (5.0 mmol), the monomer 3 shown below (3.0 mmol) and the monomer 7 shown below (1.0 mmol), the same procedure as that described for Example I was used to obtain a polymer for a hole injection layer (number average molecular weight: 5,500, weight average molecular weight: 8,500).

[Chemical formula 75]

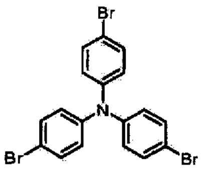

Monomer 12

+

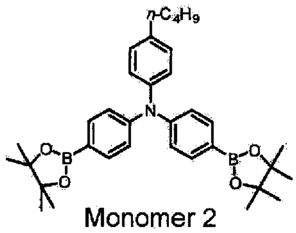

Monomer 2

+

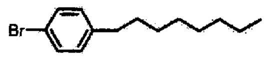

Monomer 3

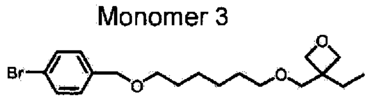

Monomer 7

(Organic EL Element C1)

The above polymer for a hole injection layer (10.0 mg), an electron-accepting compound 1 shown below (0.5 mg) and toluene (2.3 mL) were mixed together under a nitrogen atmosphere to prepare an ink composition. This ink composition was spin-coated at a rotational rate of 3,000 $min^{-1}$ onto a glass substrate on which ITO had been patterned with a width of 1.6 mm, and the ink composition was then cured by heating on a hot plate at 220°C for 10 minutes, thus forming a hole injection layer (25 nm).

[Chemical formula 76]

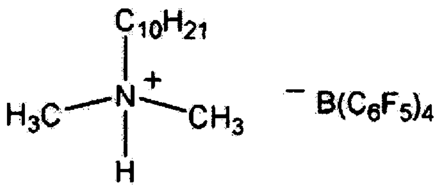

Electron-accepting compound 1

Next, the charge transport polymer C1 (10.0 mg), the electron-accepting compound 1 (0.1 mg) and toluene (1.15 mL) were mixed together to prepare an ink composition. This ink composition was spin-coated at a rotational rate of 3,000 $min^{-1}$ onto the hole injection layer formed in the manner described above, and was then cured by heating on a hot plate at 200°C for 10 minutes, thus forming a hole transport layer (30 nm). The hole transport layer was able to be formed without dissolving the hole injection layer.

The thus obtained substrate was transferred into a vacuum deposition apparatus, layers of CBP:$Ir(ppy)_3$ (94:6, 30 nm), BAlq (10 nm), TPBi (30 nm), LiF (0.8 nm) and Al (100 nm) were deposited by vacuum deposition in that order on top of the hole transport layer, and an encapsulation treatment was then performed to complete production of an organic EL element C1.

(Organic EL Elements E1 to E5 and C2)

With the exception of altering the charge transport polymer used in the formation of the hole transport layer to the various polymers shown in Table 3, Organic EL elements E1 to E5 and C2 were produced using the same method as the organic EL element C1.

When a voltage was applied to the organic EL elements C1, E1 to E5, and C2, a green light emission was confirmed in each case. For each of these organic EL elements, the emission efficiency (current efficiency) at an emission luminance of 1,000 cd/$m^2$, the drive voltage, and the emission lifespan were measured. The results of the measurements are shown in Table 3 as relative values relative to the organic EL element C1. The current-voltage characteristics were measured using a microammeter (4140B, manufactured by The Hewlett-Packard Company), and the emission luminance was measured using a luminance meter (Pritchard 1980B, manufactured by Photo Research Inc.). Further, the emission lifespan was measured by using a luminance meter (BM-7, manufactured by Topcon Corporation) to measure the luminance while a constant current was applied, and determining the time taken for the luminance to decrease by 30% from the initial luminance (5,000 cd/$m^2$) (the time required to reach a luminance of initial luminance × 0.7).

[Table 3]

Table 3

| Organic EL element | Hole transport layer Charge transport polymer | Emission efficiency | Drive voltage | Emission lifespan |
|---|---|---|---|---|
| C1 | C1 | 1 | 1 | 1 |
| E1 | E1 | 1.57 | 0.92 | 1.66 |
| E2 | E2 | 1.73 | 1.00 | 1.50 |
| E3 | E3 | 1.48 | 1.03 | 1.20 |
| E4 | E4 | 1.40 | 1.00 | 2.10 |
| E5 | E5 | 1.70 | 0.96 | 2.70 |
| C2 | C2 | 0.98 | 1.01 | 1.12 |

The organic EL elements E1 to E5 exhibited improved emission efficiency and an increased emission lifespan compared with the organic EL elements C1 and C2. For the organic EL element E2, the emission efficiency improved the most. Further, for the organic EL element E5, the improvement effect on the emission lifespan was the largest.

<Example III>

[Production and Evaluation of Organic Layers]

(Organic Layer E1)

The charge transport polymer E1 (10.0 mg), the electron-accepting compound 1 (0.5 mg) and toluene (2.3 mL) were mixed together under a nitrogen atmosphere to prepare an ink composition. This ink composition was spin-coated at a rotational rate of 3,000 $min^{-1}$ onto a quartz glass substrate (22 mm × 29 mm × 0.7 mm), and was then cured by heating on a hot plate at 220°C for 10 minutes, thus forming an organic layer E1 (25 nm). Using the method described below, the residual film ratio of the organic layer E1 was measured to evaluate the solvent resistance of the organic layer E1. The residual film ratio was 95% or higher, indicating that the organic layer E1 had excellent solvent resistance.

(Measurement of Residual Film Ratio)

The quartz glass substrate was grasped with a pair of tweezers, and immersed for one minute in a 200 mL beaker filled with toluene (25°C). The absorbance (Abs) at the absorption maximum ($\lambda$max) in the UV-vis absorption spectrum of the organic layer was measured before and after the immersion, and the residual film ratio of the organic layer was determined from the ratio between the two absorbance values using the formula below. The measurement conditions for the absorbance involved using a spectrophotometer (U-3310, manufactured by Hitachi, Ltd.) to measure the absorbance of the organic layer at the maximum absorption wavelength within the wavelength range from 300 to 500 nm.

[Numerical Formula 1]

$$\text{Residual film ratio (\%)} = \text{Abs of organic layer after immersion} / \text{Abs of organic layer before immersion} \times 100$$

(Organic Layers E2 to E5)

Organic layers E2 to E5 were produced using the charge transport polymers E2 to E5 respectively, and the residual film ratios were measured in the same manner as described above. In each case, the residual film ratio was 95% or higher. The organic layers E2 to E5 exhibited excellent solvent resistance.

The organic layers E1 to E5 had excellent solvent resistance. The organic layer according to one embodiment can be used as the lower layer beneath an upper layer that is applied by coating (for example, a coated light-emitting layer).

Reference Signs List

1: Light-emitting layer
2: Anode
3: Hole injection layer
4: Cathode
5: Electron injection layer
6: Hole transport layer
7: Electron transport layer
8: Substrate
11: Organic layer
12: Light-emitting layer

## Claims

1. An organic electronic material comprising a charge transport polymer or oligomer, wherein the charge transport polymer or oligomer:

   has a nitrogen atom and an aromatic hydrocarbon group $Ar^F$ that is bonded to the nitrogen atom and is substituted with a fluorine atom, and
   also has a structural unit containing a carbazole structure.

2. The organic electronic material according to Claim 1, wherein the charge transport polymer or oligomer has a structural unit containing an aromatic amine structure, and the structural unit has the aromatic hydrocarbon group $Ar^F$.

3. The organic electronic material according to Claim 1 or 2, wherein a nitrogen atom contained in the carbazole structure is either unsubstituted or has an aliphatic hydrocarbon group or an aromatic hydrocarbon group, and the structural unit containing a carbazole structure has the aromatic hydrocarbon group $Ar^F$.

4. The organic electronic material according to any one of Claims 1 to 3, wherein the charge transport polymer or oligomer has a polymerizable functional group.

5. The organic electronic material according to any one of Claims 1 to 4, further comprising an onium salt.

6. An ink composition comprising the organic electronic material according to any one of Claims 1 to 5 and a solvent.

7. An organic layer comprising the organic electronic material according to any one of Claims 1 to 5.

8. An organic electronic element comprising at least one of the organic layer according to Claim 7.

9. An organic electroluminescent element comprising at least one of the organic layer according to Claim 7.

10. An organic electroluminescent element comprising at least the organic layer according to Claim 7 and a light-emitting layer that contacts the organic layer.

11. An organic electroluminescent element comprising at least an anode, a hole injection layer, a hole transport layer, a light-emitting layer and a cathode, wherein the hole transport layer is the organic layer according to Claim 7.

12. A display element comprising the organic electroluminescent element according to any one of Claims 9 to 11.

13. An illumination device comprising the organic electroluminescent element according to any one of Claims 9 to 11.

14. A display device comprising the illumination device according to Claim 13, and a liquid crystal element as a display unit.

15. A method for producing an organic layer comprising a step of applying the ink composition according to Claim 6.

16. A method for producing an organic electronic element comprising a step of applying the ink composition according to Claim 6.

17. A method for producing an organic electroluminescent element comprising a step of applying the ink composition according to Claim 6.

FIG. 1

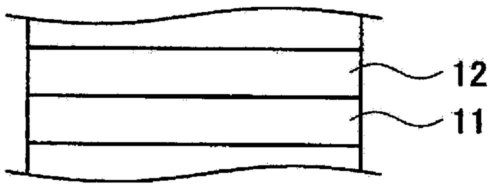

FIG. 2

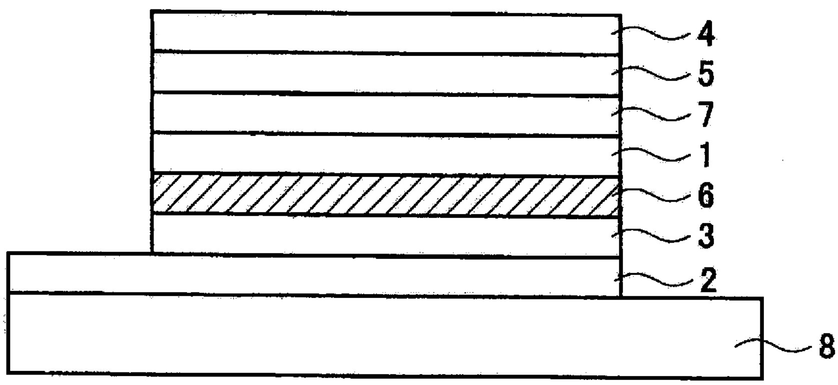

## INTERNATIONAL SEARCH REPORT

International application No. PCT/JP2017/036925

A. CLASSIFICATION OF SUBJECT MATTER
Int.Cl. H01L51/50(2006.01)i, C08G61/12(2006.01)i, H01L27/32(2006.01)i, H05B33/10(2006.01)i

According to International Patent Classification (IPC) or to both national classification and IPC

B. FIELDS SEARCHED

Minimum documentation searched (classification system followed by classification symbols)
Int.Cl. H01L51/50, C08G61/12, H01L27/32, H05B33/10

Documentation searched other than minimum documentation to the extent that such documents are included in the fields searched

| | |
|---|---|
| Published examined utility model applications of Japan | 1922-1996 |
| Published unexamined utility model applications of Japan | 1971-2017 |
| Registered utility model specifications of Japan | 1996-2017 |
| Published registered utility model specifications of Japan | 1994-2017 |

Electronic data base consulted during the international search (name of data base and, where practicable, search terms used)
CAplus/REGISTRY (STN)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2007-106793 A (SHOWA DENKO KABUSHIKI KAISHA) 26 April 2007, claims 1-12, paragraphs [0030], [0074], [0083], [0110], [0112], [0137]-[0138] (Family: none) | 1, 6-9, 12-17<br>6, 15-17 |
| X<br>Y | SPRICK, et al., "Triary lamine Polymers of Bridged Pheny lenes by (N-Heterocyclic Carbene)-Palladium Catalysed C-N Coupling", Journal of Material Chemistry C, 2013, 1, 3327-3336 | 1-2, 7-14<br>4-6, 15-17 |

☒ Further documents are listed in the continuation of Box C.

☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>21 December 2017 (21.12.2017) | Date of mailing of the international search report<br>09 January 2018 (09.01.2018) |
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

INTERNATIONAL SEARCH REPORT

International application No.
PCT/JP2017/036925

C (Continuation). DOCUMENTS CONSIDERED TO BE RELEVANT

| Category* | Citation of document, with indication, where appropriate, of the relevant passages | Relevant to claim No. |
|---|---|---|
| X<br>Y | ALEKSANDROVA, et al., "Spectroscopic Study of Polyphenylquinolines-Material with Efficient Intramolecular Charge Transfer", Optics and Spectroscopy, 2013, 114, 5, 737-750 | 1, 3, 7-9, 12-14<br>6, 15-17 |
| X<br>Y | CHAUHAN, et al., "N-Aryl 2, 7-Linked Carbazole Polymers and Copolymers with Fluorine Protecting Groups: A New Class of Blue Emitting Polymers for LED Applications", Molecular Crystals and Liquid Crystals, 2008, 497, 129-141 | 1, 3, 7-9, 12-14<br>6, 15-17 |
| Y | JP 2015-159077 A (HITACHI CHEMICAL CO., LTD.) 03 September 2015, claims 1, 8 (Family: none) | 4-5 |
| A | CN 102757560 A (SUN YAT-SEN UNIVERSITY) 31 October 2012, entire text (Family: none) | 1-17 |
| P, A | WO 2017/119483 A1 (HITACHI CHEMICAL CO., LTD.) 13 July 2017, entire text (Family: none) | 1-17 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2011040531 A
- JP 2016201884 A
- JP 2000036390 A
- JP 2005075948 A
- JP 2003213002 A


### Non-patent literature cited in the description


- *Adv. Mater.,* 2009, vol. 21, 4802-4906
- *Appl. Phys. Lett.,* 2011, vol. 98, 083302
- *Chem. Comm.,* 2012, vol. 48, 9580
- *Appl. Phys. Lett.,* 2012, vol. 101, 093306
- *J. Am. Chem. Soc.,* 2012, vol. 134, 14706
- *Chem. Comm.,* 2012, vol. 48, 11392
- *Nature,* 2012, vol. 492, 234
- *Adv. Mater.,* 2013, vol. 25, 3319
- *J. Phys. Chem. A,* 2013, vol. 117, 5607
- *Phys. Chem. Chem. Phys.,* 2013, vol. 15, 15850
- *Chem. Comm.,* 2013, vol. 49, 10385
- *Chem. Lett.,* 2014, vol. 43, 319